(19) **Europäisches Patentamt European Patent Office Office européen des brevets**

(11) **EP 4 675 950 A1**

(12) **EUROPEAN PATENT APPLICATION**

(43) Date of publication:
07.01.2026 Bulletin 2026/02

(21) Application number: 25186999.6

(22) Date of filing: 02.07.2025

(51) International Patent Classification (IPC):
**H04L 1/00** (2006.01)

(52) Cooperative Patent Classification (CPC):
**H03M 13/116; H03M 13/618; H03M 13/6516; H04L 1/0043; H04L 1/0057;** H03M 13/118; H03M 13/616; H03M 13/635

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH LA MA MD TN**

(30) Priority: 03.07.2024 US 202463667255 P
10.06.2025 US 202519233753
10.06.2025 US 202519233767
10.06.2025 US 202519233776
10.06.2025 US 202519233788

(71) Applicant: **Avago Technologies International Sales Pte. Limited**
**Singapore 768923 (SG)**

(72) Inventors:
• **PULIKKOONATTU, Rethnakaran**
**92618, Irvine (US)**
• **BLANKSBY, Andrew**
**Irvine, 92618 (US)**

(74) Representative: **Dilg, Haeusler, Schindelmann Patentanwaltsgesellschaft mbH**
**Leonrodstraße 58**
**80636 München (DE)**

(54) **SYSTEMS AND METHODS FOR QUASI-CYCLIC LOW DENSITY PARITY CHECK (QC-LDPC) CODE WITH 1/2 CODE RATE**

(57) Transmitter or receiver configured to identify, based at least on a first parity check matrix of a first quasi-cyclic-low-density parity-check, QC-LDPC, code according to a code rate R of 1/2, a second parity check matrix for a second QC-LDPC code, wherein the second QC-LDPC code has a code block size that is four times a code block size of the first QC-LDPC code. Encode or decode code data using the second parity check matrix. The code block size of the second QC-LDPC code may be 7776 bits.

100

Fig. 1

EP 4 675 950 A1

**Description**

**Cross-Reference to Related Applications**

This application claims the benefit of priority to each of U.S. Provisional Patent Application No. 63/667,255 filed on July 3, 2024, which is incorporated herein by reference in its entirety for all purposes.

**Field of the Disclosure**

This disclosure generally relates to systems and methods for improving an encoding process and/or a decoding process of a communications system using a quasi-cyclic-low-density parity-check (QC-LDPC) code.

**Background**

Error correcting codes enable information data to be exchanged between a transmitter communication system and a receiver communication system in a reliable manner. A transmitter communication system encodes the information data to obtain a codeword. The codeword is encoded information data. The transmitter communication system transmits the codeword to the receiver communication system. Due to noise in the communication channel, the transmission received by the receiver communication system may not be identical to the transmitted codeword. Encoding information data allows a receiver communication system with a proper decoding process to recover the information data from the received transmission despite such noise. For example, the transmitter communication system transmits parity bits to the receiver communication system. The parity bits allow the receiver communication system to verify whether the received transmission is a valid codeword and to correct errors in the transmission if the received transmission is not a valid codeword. In one approach, generating parity bits involves a complex process.

**Brief Description of the Drawings**

Various objects, aspects, features, and advantages of the disclosure will become more apparent and better understood by referring to the detailed description taken in conjunction with the accompanying drawings, in which like reference characters identify corresponding elements throughout. In the drawings, like reference numbers generally indicate identical, functionally similar, and/or structurally similar elements.

FIG. 1 is a diagram depicting an example communication environment with communication systems, according to one or more embodiments.

FIG. 2 is a schematic block diagram of a computing system, according to an embodiment.

FIG. 3 is a diagram depicting an example exponent matrix, according to one or more embodiments.

FIG. 4 is a diagram depicting example shifted identity matrices for generating a parity check matrix, according to one or more embodiments.

FIG. 5 is a diagram depicting an example parity check matrix, according to one or more embodiments.

FIG. 6 is a diagram depicting an example exponent matrix, according to one or more embodiments.

FIG. 7A, FIG. 7B and FIG. 7C are diagrams depicting an example exponent matrix and example binary parity check matrices, according to one or more embodiments.

FIG. 8A, FIG. 8B and FIG. 8C are diagrams depicting an example of sequential Khatri-Rao style lifting from a base code to a new code with a longer block length, and binary matrices (referred to as "gamma matrix" or "$\Gamma$ matrix") used for the lifting, according to one or more embodiments.

FIG. 9A and FIG. 9B are diagrams depicting an example of Khatri-Rao style lifting from a base code to a new code with a longer block length, and a binary matrix (referred to as "lambda matrix" or "$\lambda$ matrix") used for the lifting, according to one or more embodiments.

FIG. 10 is a flow diagram showing a process for encoding data and/or decoding data using an LDPC code, in accordance with an embodiment.

The details of various embodiments of the methods and systems are set forth in the accompanying drawings and the description below.

**Detailed Description**

The following disclosure provides many different embodiments, or examples, for implementing different features of the provided subject matter. Specific examples of components and arrangements are described below to simplify the present disclosure. These are, of course, merely examples and are not intended to be limiting. For example, a first feature in communication with or communicatively coupled to a second feature in the description that follows may include embodiments in which the first feature is in direct communication with or directly coupled to the second feature and may also include embodiments in which additional features may intervene between the first and second features, such that the first feature is in indirect communication with or indirectly coupled to the second feature. In addition, the present disclosure may repeat reference numerals and/or letters in the various examples. This repetition is for the purpose of simplicity and clarity and does not in itself dictate a relationship between the various embodiments and/or configurations discussed.

In one aspect, a parity check matrix defines a set of equations that are satisfied by any valid codeword. The parity check matrix may be used for encoding low density parity check ("LDPC") codes, described by Richardson and Urbanke in IEEE Transactions on Information Theory, Vol. 47, No. 2 (February 2001). Generally, many wireless and wireline communication systems use LDPC as a forward error correction coding scheme. However, the longest block length (in bit) for coded data, supported in the 802.11 standards (e.g., 802.11n-802.11be) is 1944. There may be a limited gain in a radio channel (e.g., 2x2 multiple-input and multiple-output channels) that can be achieved using the block length of 1944.

To solve this problem, according to certain aspects, embodiments in the present disclosure relate to a technique to support or provide an LDPC code with the block length of 7776 and the code rate of 1/2. The block length of 7776 is 4 times that of the longest code supported in 802.11n-802.11be standards (e.g., the block length of 1944). In some embodiments, the LDPC code has a quasi-cyclic (QC) structure which helps in efficient encoding and decoding. In some embodiments, QC-LDPC codes may be a class of structured LDPC codes, which may be used in many practical applications including the IEEE 802.11n, 802.11ac, 802.11ax, 802.11be standards. In QC-LDPC codes, a parity check matrix has a cyclic structure that repeats itself in a quasi-cyclic manner, which can simplify the encoding and decoding processes, making QC-LDPC codes more efficient. The code block size (denoted by n) refers to a total number of coded or transmitted bits as a result of encoding data using an error correction code (e.g., LDPC). The number of information bits (denoted by k) refers to a number of bits that carry the data to be subject to the encoding using the error correction code. The code rate (denoted by R) refers to a ratio of the number of information bits to the code block size (R=k/n). In some embodiments, an LDPC encoder may take a block of k bits of information bits (e.g., k=3888) and produce n coded bits with the code rate R=k/n (e.g., R=1/2, n=7776). An LDPC decoder may operate on (noisy version of ) n received bits and (ideally) recover the k information bits. In some embodiments, the LDPC encoder may take a block of k bits of information bits as input, encode the block of k bits to produce a block of n coded bits (e.g., n=7776) with the code rate 1/2 (R=k/n).

In some implementations, an apparatus may include a transmitter and one or more processors. The one or more processors may be configured to identify, based at least on a first parity check matrix of a first quasi-cyclic-low-density parity-check (QC-LDPC) code according to a code rate R of 1/2, a second parity check matrix for a second QC-LDPC code. The second QC-LDPC code may have a code block size that is four times a code block size of the first QC-LDPC code. The one or more processors may be configured to encode data using the second parity check matrix. The transmitter may be configured to transmit the encoded data. In some implementations, the code block size of the second QC-LDPC code may be 7776 bits.

In some implementations, the one or more processors may be configured to identify the first parity check matrix of the first QC-LDPC code having the code rate of 1/2. The one or more processors may be configured to determine a first binary matrix, and determine, based at least on the first parity check matrix and the first binary matrix, a first Khatri-Rao product. The one or more processors may be configured to determine, using the first Khatri-Rao product, the second parity check matrix.

In some implementations, in determining the second parity check matrix, the one or more processors may be configured to determine, using the first Khatri-Rao product, a third parity check matrix, and determine a second binary matrix having the same size as a size of the first binary matrix. The one or more processors may be configured to determine, based at least on the third parity check matrix and the second binary matrix, a second Khatri-Rao product. The one or more processors may be configured to determine, using the second Khatri-Rao product, the second parity check matrix.

In some implementations, the first binary matrix may include the following set of values: [0 1 1 1 1 0 0 1 0 1 0 1 1 1 0 0 1 0 1 1 0 0 1 1 1 1 0 0 1 0 1 0 1 1 1 0 1 0 1 0 1 0 0 1 0 0 1 0 0 1 1 1 1 1 0 1 0 0 1 0 1 1 1 1 1 0 0 1 0 0 1 0 0 1 1 0 1 1 1 0 1 1 0 0 0 1 0 1 1 1 0 1 1 0]. The second binary matrix may include the following set of values: [1 0 0 1 1 0 1 0 0 1 1 0 1 0 01110100111001

0 1 0 0 1 1 1 1 0 1 0 0 0 0 1 1 1 0 0 1 1 1 1 0 1 1 0 0 1 1 1 0 0 0 1 1 1 0 1 1 0 1 0 0 1 0 1 1 1 1 1 1 1 0 1 1 1 0 1 1 1 0 1 0 1 0 1 1 0].

In some implementations, the first binary matrix may have a dimension that (1) is different from a dimension of an exponent matrix corresponding to the first parity check matrix and (2) is the same as a dimension of an exponent matrix corresponding to the second parity check matrix. In some implementations, an exponent matrix corresponding to the first parity check matrix may have a dimension of (24(1-R) $\times$ 24). An exponent matrix corresponding to the second parity check matrix may have a dimension of (96(1-R) $\times$ 96). The first binary matrix may have a dimension of (96(1-R) $\times$ 96).

Generally, a parity check matrix for a code represents equations that determine whether errors have occurred during transmission. More formally, for all valid codewords (i.e., bits produced by the encoder with no errors), the following equation can be true:

$$Hc=0 \ldots\ldots\ldots\ldots (Equation\ 1)$$

In Equation 1, "H" is the parity check matrix, "c" is a codeword vector, and "0" is a vector of all zeroes. The parity check matrix, H, is one way of describing a code.

A generator matrix for a code, G, satisfies the following equation:

$$sG=c \ldots\ldots\ldots\ldots (Equation\ 2)$$

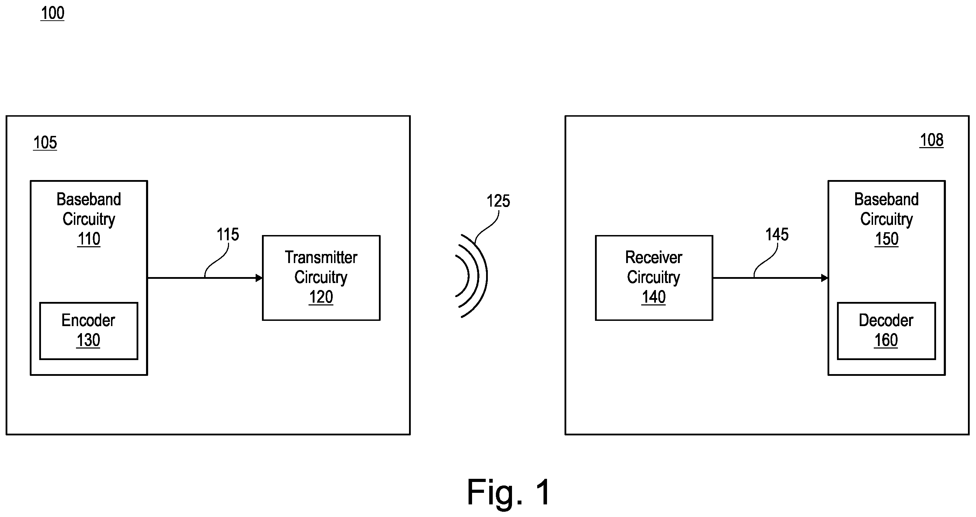

In Equation 2, "s" is a vector of information bits, "G" is a generator matrix and "c" is the codeword that corresponds to "s." In some embodiments, a system (e.g., a communication system 108 including a decoder 160 in FIG. 1) can decode the codeword c to obtain the decoded data s using Equation 2.

The parity check and generator matrices for a code are related per the above matrix equations. Generally, if a parity check matrix is low density, the corresponding generator matrix will be high density, and vice versa. LCPC codes are accordingly characterized by low density parity check matrices and high density generator matrices. The density of a matrix relates to the number of operations that must be performed to implement one of the above equations. Although it was recognized by 1995 that LDPC codes could be used to transmit data with very few errors, i.e., with error rates as good or better than turbo codes, one disadvantage of LDPC codes is that their generator matrices were high density and that made encoding computationally intensive, rending the codes impractical for many applications.

In some implementations, a parity check matrix may have a quasi-cyclic structure, for example, a parity check matrix for QC-LDPC code (n=7776, k=3888, R=1/2). Given a lifting size z, the parity check matrix may have a plurality of sub-matrices such that each submatrix is cyclically shifted version of an identity matrix of size (z x z), where z=81, for example. A parity check matrix can be represented in two equivalent forms: (1) parity check matrix H and (2) a block matrix or an exponent matrix P=E(H).

In some implementations, a parity check matrix H may be a binary matrix whose size is m x n (each of m and n is an integer). Elements of the parity check matrix are binary values. Given a block length n and a code rate R, an LDPC code (or QC-LDPC code) LDPC (n, R) satisfies the following equations:

$$k=nR \ldots\ldots\ldots\ldots (Equation\ 3)$$

$$m=n(1-R) \ldots\ldots\ldots\ldots (Equation\ 4)$$

In some implementations, a block matrix or an exponent matrix (QC-LDPC exponent matrix) may be obtained. Given a lifting size z, the exponent matrix P=E(H) may have a size of m/z x n/z. If n=24z (e.g., n=7776, z=324), then the size of P=E(H) is 24(1-R) x 24 (= n(1-R)/z x n/z). Elements of the exponent matrix may be integer values which correspond to cyclic shift values of identity matrix of size z x z. A parity check matrix H may be a sparse binary matrix that can be derived from an exponent matrix P=E(H). The generator matrix G may have a size n x k in binary form (e.g., elements of the generator matrix G are binary values). The exponent matrix P=E(H) may have a structure including a plurality of sub-matrices (e.g., A, B, C, D, E, T).

In some implementations, a binary QC-LDPC code LDPC (n, R) may be characterized by the null space of an n(1-R)$\times$n parity check matrix H. The parity check matrix H may be a binary sparse matrix which includes a set of circulant matrices of size z x z. The parity-check matrix H of a QC-LDPC code can be represented equivalently by an exponent matrix P=E(H). This representation can help to illustrate the graphical structure of the underlying code as a base graph along with coefficient of shifting.

In some implementations, a parity check matrix H may be generated from an exponent matrix P=E(H). The exponent matrix P=E(H) may include (as elements) shift values d in the range 0<=d<z along with d=-1. For example, if z=7, the shift values d may include -1, 0, 1, 2, 3, 4, 5, 6. The shift value d=0 may correspond (or map) to an identity matrix of size z x z, denoted by I(z). The shift value d=-1 may correspond (or map) to a null matrix (all elements zero) of size z x z, denoted by 0*I(z). Any other integer value d in [1,z-1] may correspond (or map) to a matrix cyclically right shifted from I(z). The parity check matrix H can be obtained from the exponent matrix P=E(H) by expanding the exponent matrix P such that each element of the exponent matrix P (as a shift value d) is replaced by a matrix corresponding to the shift value.

In some implementations, the exponent matrix P=E(H) may include a plurality of elements P1,1, P1,2, P1,3, ..., P1,ń; P2,1, P2,2, P2,3, ..., P2,ń; ..., P1,1, P1,2, P1,3, ..., Pṁ,ń, which correspond to (ṁ x ń) values where ṁ and ń satisfy the following equations:

$$\acute{m}= n(1-R)/z \ldots\ldots\ldots\ldots \text{(Equation 5)}$$

$$\acute{n} = n/z \ldots\ldots\ldots\ldots \text{(Equation 6)}$$

The exponent matrix (or permutation matrix) P=E(H) may be expressed as following:

$$P \equiv E(H) = \begin{pmatrix} P_{1,1} & P_{1,2} & P_{1,3} & \cdots & \cdots & P_{1,\acute{n}} \\ P_{2,1} & P_{2,2} & P_{2,3} & \cdots & \cdots & P_{2,\acute{n}} \\ \cdots & \ddots & \ddots & \cdots & \cdots & \vdots \\ P_{\acute{m},1} & P_{\acute{m},2} & P_{\acute{m},3} & \cdots & \cdots & P_{\acute{m},\acute{n}} \end{pmatrix} \ldots\ldots\ldots\ldots \text{(Equation}$$

7)

The corresponding parity check matrix H may be obtained by replacing each element of the matrix (as a shift value d) by a matrix C(d) corresponding to the shift value as follows:

$$H = \begin{pmatrix} C\,(P_{1,1}) & C\,(P_{1,2}) & C\,(P_{1,3}) & \cdots & \cdots & C\,(P_{1,\acute{n}}) \\ C\,(P_{2,1}) & C\,(P_{2,2}) & C\,(P_{2,3}) & \cdots & \cdots & C\,(P_{2,\acute{n}}) \\ \cdots & \ddots & \ddots & \cdots & \cdots & \vdots \\ C\,(P_{\acute{m},1}) & C\,(P_{\acute{m},2}) & C\,(P_{\acute{m},3}) & \cdots & \cdots & C\,(P_{\acute{m},\acute{n}}) \end{pmatrix} \ldots\ldots\ldots\ldots \text{(Equation}$$

8)

For example, a matrix C(1) may be expressed as follows:

$$C(1) = \begin{pmatrix} 0 & 1 & 0 & \cdots & \cdots & 0 \\ 0 & 0 & 1 & \cdots & \cdots & \ddots \\ \ddots & \ddots & \ddots & \cdots & \cdots & \vdots \\ 0 & 0 & 0 & \cdots & \cdots & 1 \\ 1 & 0 & 0 & \cdots & \cdots & 0 \end{pmatrix} \ldots\ldots\ldots\ldots \text{(Equation 9)}$$

In some implementations, an encoder can produce codewords using a generator matrix (e.g., using Equation 2). In some embodiments, an encoder can use the parity check matrix (rather than the generator matrix) to produce codewords from vectors of information bits. After a parity check matrix H is obtained, the parity check matrix H may have sub-matrices A, B, C, D, T, E. An upper area O of the sub-matrix T may correspond to an area in which the matrix contains all zeroes, and the other areas may represent locations that can contain ones.

In some implementations, the codeword c can be obtained by the following expression:

$$c = [s\ p1\ p2] \ldots\ldots\ldots\ldots \text{(Equation 10)},$$

where "s" is the vector of information bits to be encoded, **"$p_1$"** is a vector of the first g parity bits and **"$p_2$"** is a vector of the remaining m-g parity bits.

The vectors p1 and p2 can be obtained by the following equations:

$$\Phi = -ET^{-1}B+D \ldots\ldots\ldots\ldots \text{(Equation 11)};$$

$$p_1^T = -\Phi^{-1}\ (-ET^{-1}A+C)\ s^T \ldots\ldots\ldots\ldots \text{(Equation 12)};$$

and

$$p_2^T = -T^{-1}\ (As^T+Bp_1^T) \ldots\ldots\ldots\ldots \text{(Equation 13)}.$$

Although various embodiments disclosed herein are described for encoding data for a wireless communication (e.g., wireless local area network (WLAN) conforming to any IEEE 802.11 standard), principles disclosed herein are applicable to other types of communication (e.g., wired communication) or any process that performs encoding for LDPC codes.

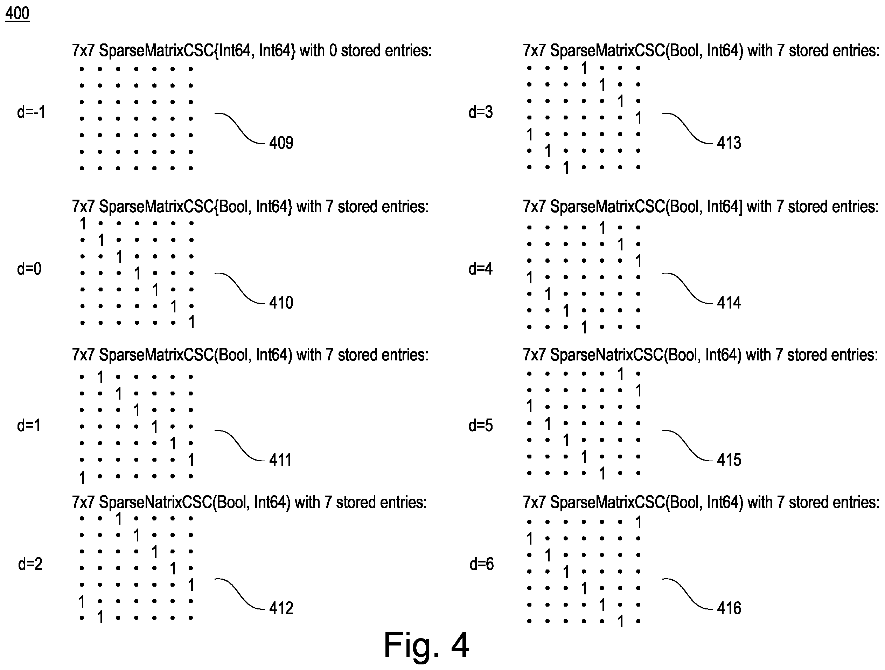

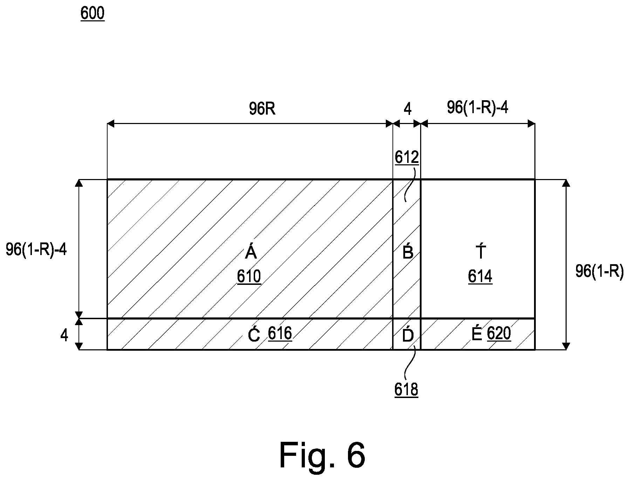

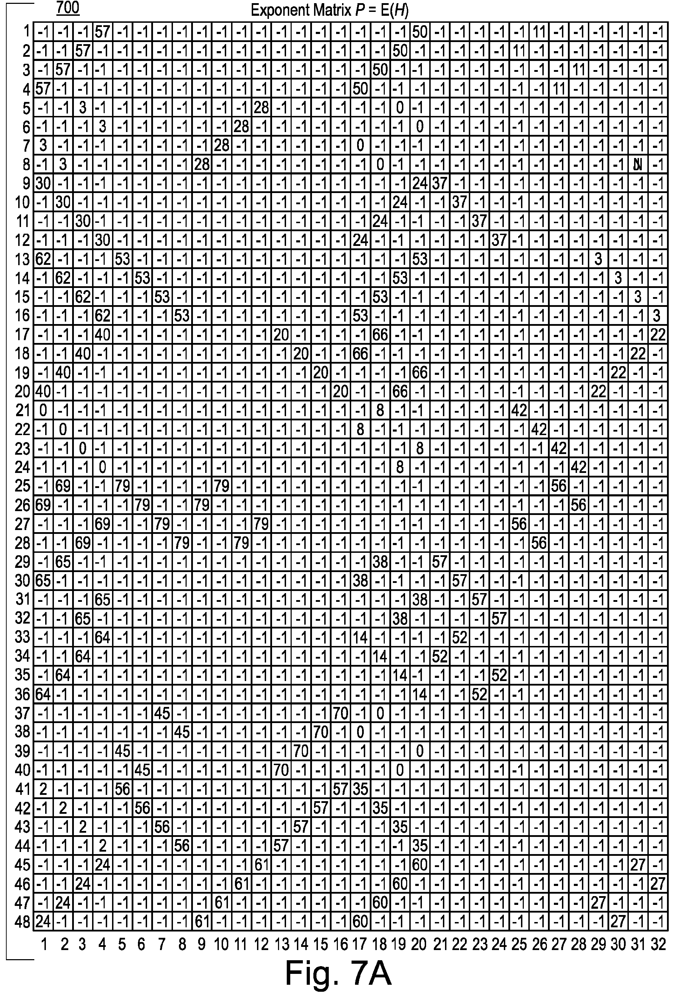

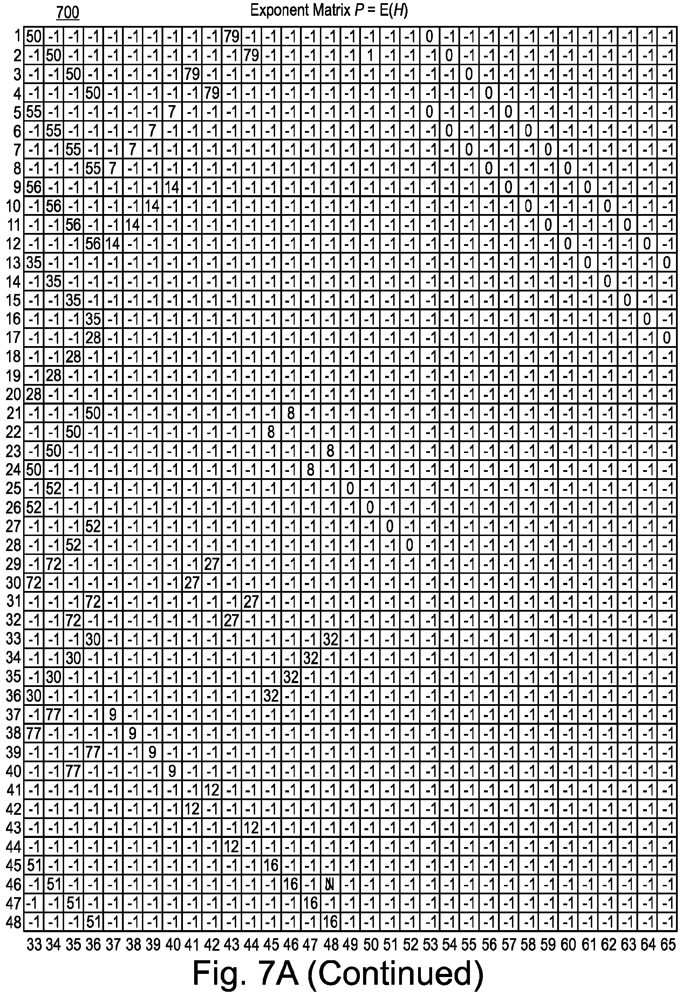

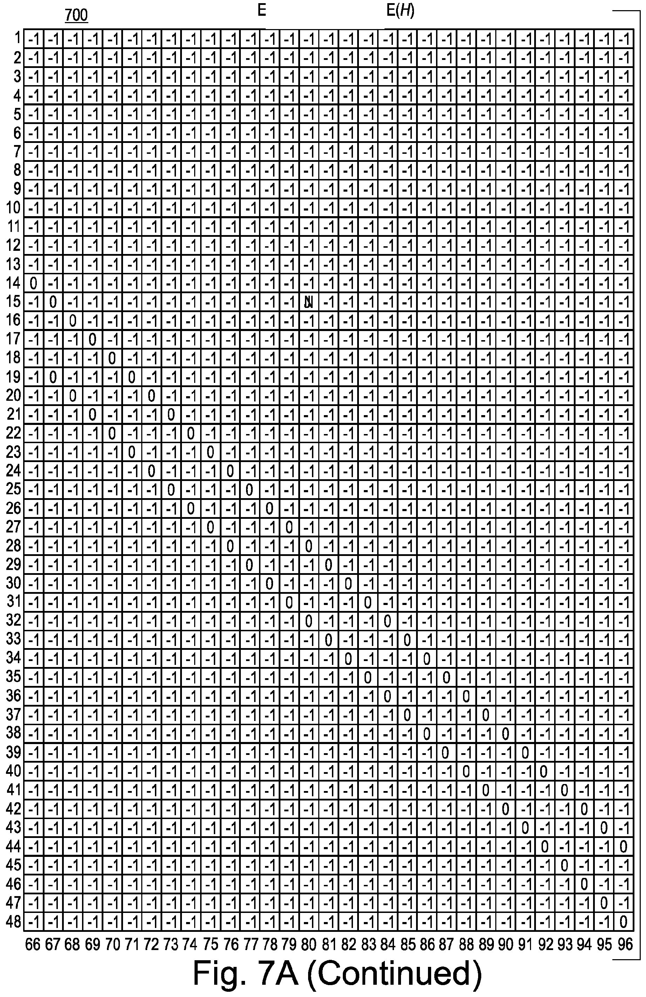

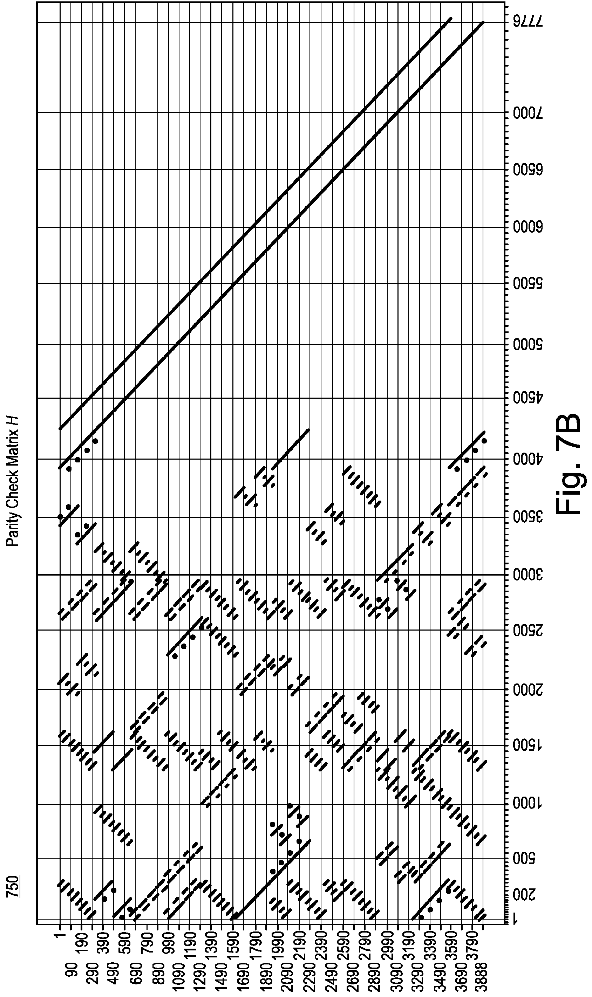

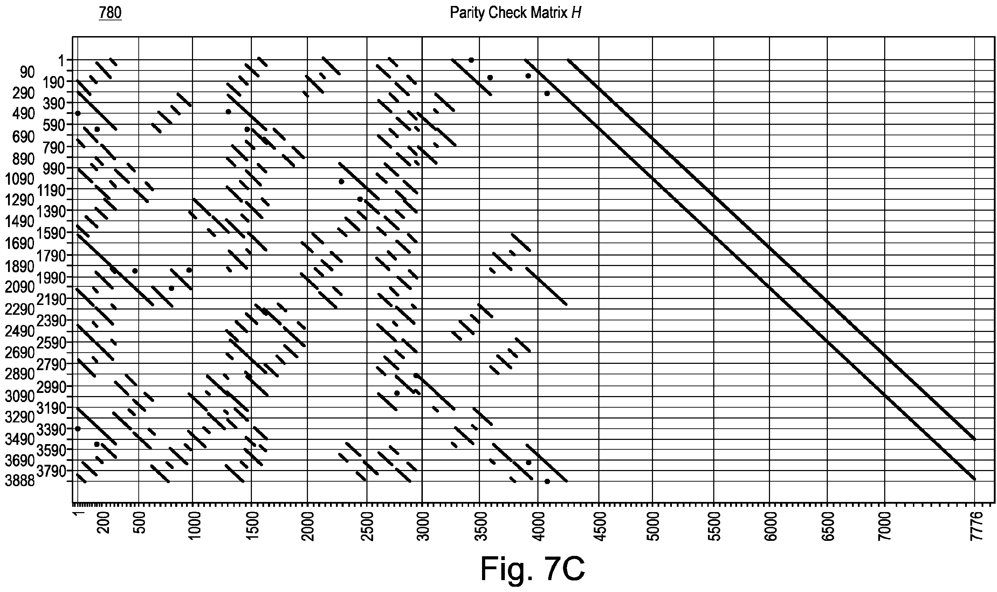

In some implementations, the system can define, generate, or create a new Quasi Cyclic (QC)-LDPC codebook of blocklength n = 7776 bits, rate R= 1/2, and information length k = 1/2*7776 =3888 bits. The system can define, generate, or create a parity check matrix H (see FIG. 7B and FIG. 7C) which has size = (1-R)*n x n = 3888 x 7776. The system can define, generate, or create an exponent matrix E(H) (see FIG. 7A) which is equivalent to H. E(H) has size 96*(1-R) x 96 and contains cyclic shift values such that each of the entries gets mapped to circulant matrix of size Z=81 (see FIG. 6). Elements of E(H) are integers between -1 and Z-1 (Z=81). The codebook can be defined in terms of E(H). E(H) can be mapped to H using Equations 7-9 as shown FIG. 4. The new QC-LDPC code of blocklength n = 7776 bits and rate R= 1/2 according to some implementations can have the following code properties: (1) the code has nested embedding of the corresponding rate code of blocklength = 1944 specified in the IEEE 802.11n specification; and (2) at a first level, the code can be viewed as a lifted version of the 3888 length code.

In some implementations, the system can perform encoding of data either using the parity check matrix (see FIG. 7B and FIG. 7C) using methods such as direct encoding, resource unit (RU) encoding or its variants. Here, "RU encoding" refers to a method where different RUs within a channel can use different modulation and coding schemes (e.g., QAM levels and LDPC code rates) to adapt to varying channel conditions. In some implementations, the system can encode data using the equivalent generator matrix G according to Equation 2. The generator matrix G can be equivalent to parity check matrix H and can be in the null space of H.

In some implementations, the system can perform decoding of data using message passing based algorithms. In some implementations, the new QC-LDPC code of blocklength n = 7776 bits and rate R= 1/2 according to some implementations can have an embedding of the 1944 length code of the same rate, and thus the system can re-use all existing (encoding and/or decoding) circuitry of 1944 length code along with further parallelism.

In some implementations, a system and/or a method can generate LDPC codes having code rate of 1/2 using Khatri-Rao lifting (e.g., using Khatri-Rao product). For example, the system can use a base LDPC code (as mother code) to recursively construct LDPC codes having a block length that is double the block length of the base LDPC code. The mother code can be defined by a parity check matrix H or an exponent matrix P=E(H) as in QC-LDPC code. Each entry in P may be an integer value, corresponding to a cyclic shift value of an identity matrix of size z x z.

In some implementations, the system can determine (e.g., calculate, compute, obtain) a binary matrix $\Gamma$, which has the same size (or dimension) as P=E(H). The binary matrix $\Gamma$ may internally include sub-matrices which are powers of exchange matrix $J(2)=\begin{pmatrix} 0 & 1 \\ 1 & 0 \end{pmatrix}$, e.g., an exchange matrix of order 2. The matrix $\Gamma$ whose non-zero values (1) may be randomized such that the rank of the binary matrix maintains to be full rank while the binary matrix conforms to good LDPC code performances (e.g., achieving low packet error rates). The system can perform a computer search (e.g., search using one or more processors) to identify the most optimal $\Gamma$ that can yield the least packet error performance (e.g., packet error rate (PER)). For example, the matrix $\Gamma$ can maintain to have full rank, which equals 24(1-R), for a Wi-Fi code with code rate R. For example, for a code rate of R=1/2, the binary matrix $\Gamma$ may have a dimension of 12x24 (12 rows, 24 columns) and have full rank of 12 (=24(1-1/2)). The rank of a matrix refers to a maximal number of linearly independent columns of the matrix or a dimension of the vector space generated by the columns of the matrix.

In some implementations, LDPC codes generated (e.g., constructed, created) using a Khatri-Rao lifting scheme

can be used to design Wi-Fi LDPC codes of block length=7776 bits from existing LDPC codes of block length=1944 bits.

Khatri-Rao product is an extension to the operation of block wise Kronecker products when the involved matrices are suitably partitioned. Khatri-Rao product can be defined as follows. Consider two matrices A, B of orders (dimensions or sizes) u $\times$ v and p $\times$ q, respectively. In compart form, $A = (a_{i,j})$ and $B = (b_{k,l})$ . Further let $A = (A_{i,j})$ be partitioned with $A_{i,j}$ of order $u_i \times v_j$ as (i, j)$^{th}$ sub-matrix block, and $B = (B_{i,j})$ be partitioned with $B_{i,j}$ of order $p_k \times q_l$ as (k, l)$^{th}$ sub-matrix block, where $\Sigma_i u_i = u$, $\Sigma_j v_j = v$, $\Sigma_k p_k = p$, $\Sigma_l q_l = q$. Khatri-Rao product operation of two matrices A and B can be defined as follows:

$$A \circledast B = \left(A_{i,j} \otimes B_{i,j}\right)_{i,j} \ldots\ldots\ldots\ldots \text{ (Equation 14)}$$

where $\circledast$ is the Khatri-Rao product operation, $A_{i,j} \otimes B_{i,j}$ is the Kronecker product of order $u_i p_i \times v_j q_j$ and the overall output $A \circledast B$ has order $\Sigma_i u_i p_i \times \Sigma_j v_j q_j$. Extension to block wise Kronecker products when the involved matrices can be well partitioned. An example of calculating Khatri-Rao product is shown as follows. Let

$$A = \begin{pmatrix} 1 & 0 & 2 & 7 \\ 3 & 6 & 2 & 3 \end{pmatrix}$$

$$B = \begin{pmatrix} -1 & -2 & 5 & 9 & 9 & 2 & 8 & 1 \\ 5 & 1 & 0 & 4 & 3 & 8 & 9 & 3 \\ 3 & -1 & 8 & 8 & 3 & 9 & 0 & 2 \\ 2 & 0 & 9 & 3 & 9 & 1 & 6 & 5 \end{pmatrix}$$

Then, with $u_i = 1$, $v_i = 1$, $1 \le i \le 2, 1 \le j \le 4$ and $p_k = q_l = 2, 1 \le k \le 2, 1 \le l \le 4$, the Khatri-Rao product of A and B is given by

$$A \circledast B = \begin{pmatrix} -1 & -2 & 0 & 0 & 18 & 4 & 56 & 7 \\ 5 & 1 & 0 & 0 & 6 & 16 & 63 & 21 \\ 9 & -3 & 48 & 48 & 6 & 18 & 0 & 6 \\ 6 & 0 & 54 & 18 & 18 & 2 & 18 & 15 \end{pmatrix}$$

In some embodiments, the system can perform (e.g., calculate, compute) Khatri-Rao lifting as follows. Let $P \equiv E(H)$ be an exponent matrix corresponding to a parity check matrix H of a QC-LDPC code. The exponent matrix may include integer values between -1, 0, ..., z-1 where z is a design parameter of the code. For block length of 1944, the system may use z=81 for Wi-Fi error correction codes. The parity check matrix H can be obtained from the P matrix, by cyclic shifting identity matrix $\mathbb{I}^{Z \times Z}$ by the constituent entries of P. The system can determine (e.g., calculate, compute, obtain) new code matrices $\acute{H}$ and $\acute{P} = E(\acute{H})$ using Equation 15 as follows.

$$H' = H \circledast J^{\odot \Gamma} - J^{\odot(\mathbb{1}_{uxv} - \Gamma)} \ldots\ldots\ldots\ldots \text{ (Equation 15)}.$$

where $\circledast$ is the Khatri-Rao product operation, $\Gamma$ is a binary matrix, $\mathbb{1}$ is the all one matrix whose order (dimension or size) is the same as the $\Gamma$ matrix (e.g., u $\times$ v), and $J = J(2) = \begin{pmatrix} 0 & 1 \\ 1 & 0 \end{pmatrix}$ is called the exchange matrix of order 2. $\odot$ is an operation involving matrix exponent defined as follows:

$$A^{\odot B} \triangleq \left(A^{B_{i,j}}\right)_{i=1:u, j=1:v} , B \in \mathbb{F}_2^{u \times v} \ldots\ldots\ldots\ldots \text{ (Equation 16)}.$$

where B has a dimension of (u $\times$ v).

In some implementations, the system can generate (e.g., calculate, compute, obtain) a (new) parity check code by calculating a Khatri-Rao product of a parity check matrix (of size m x n) of a base code and a binary (random) matrix $\Gamma$ (using Equation 16). In some implementations, the system may determine the binary matrix $\Gamma$ by iteratively changing an entry of the matrix and finding one or more best matrices in terms of the number of shortest loops and/or packet error performance.

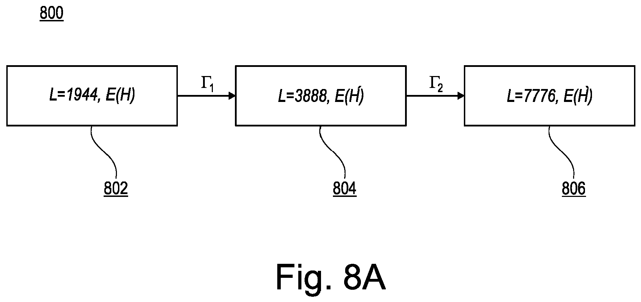

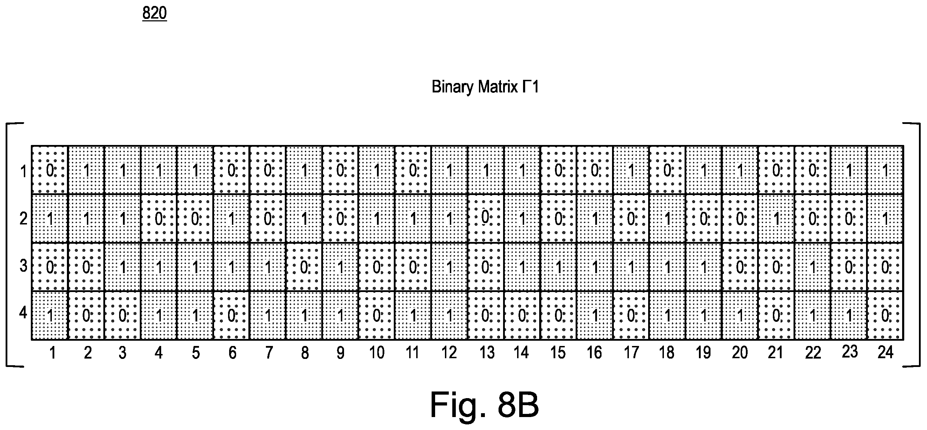

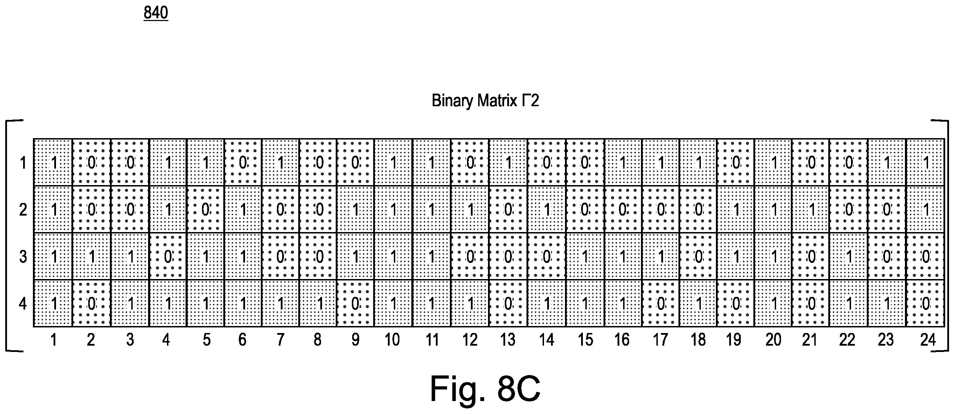

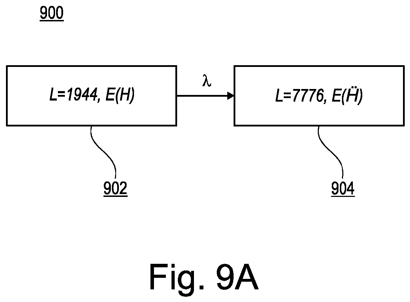

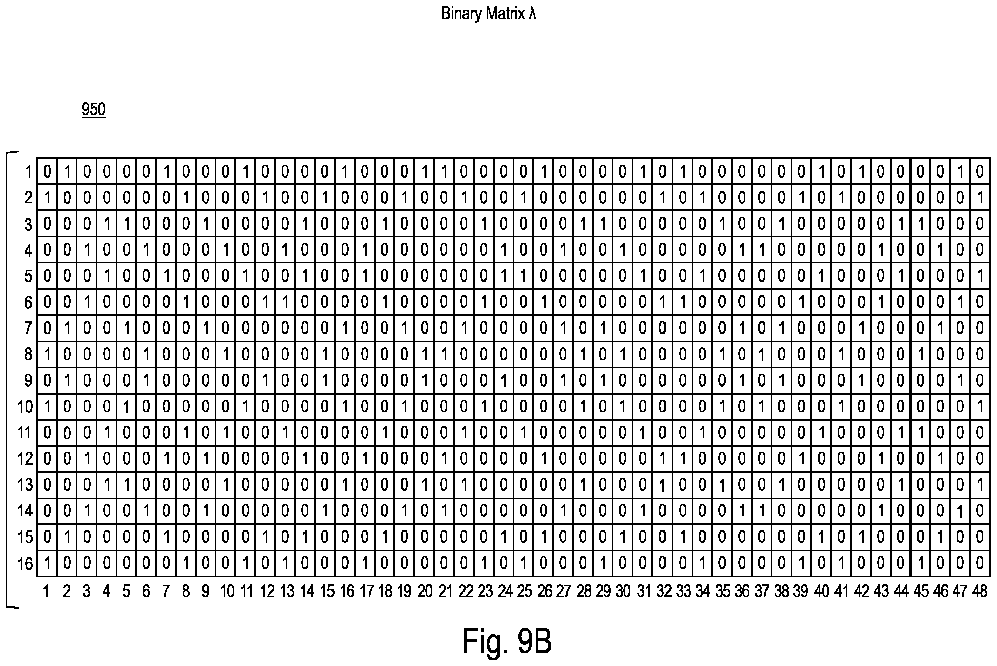

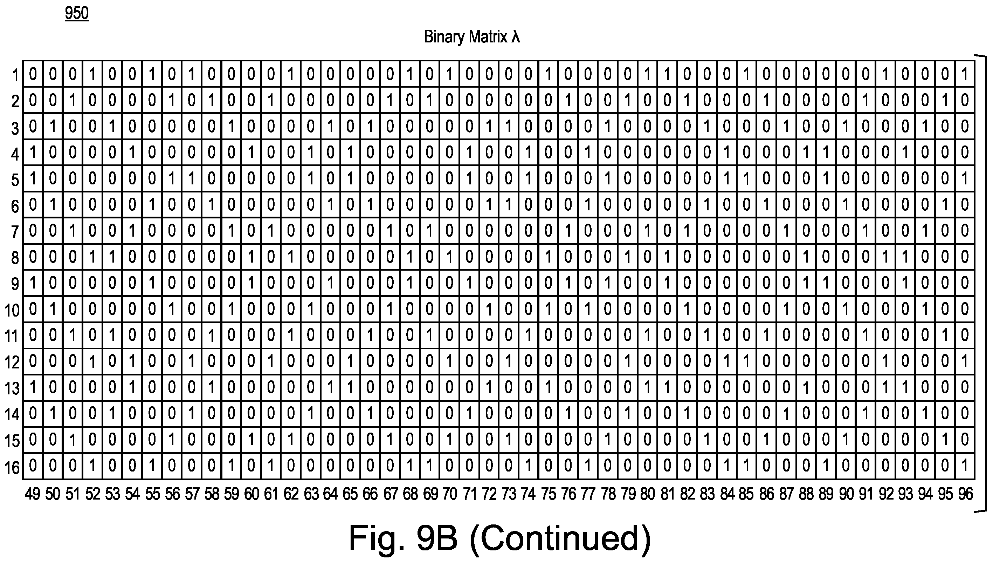

In some implementations, the system can define (e.g., calculate, compute, obtain, generate) the base code as a parity check matrix H or an exponent matrix E(H) as in QC-LDPC code. The system can calculate (e.g., generate, compute, obtain, determine) the binary matrix $\Gamma$, which has the same size as E(H). In some implementations, if H is chosen as the representation of the parity check matrix, the matrix $\Gamma$ can have the same size as H. The matrix $\Gamma$ can internally include sub-matrices which are powers of exchange matrix J(2). The binary matrix $\Gamma$ whose non-zero values (e.g., value "1") can be randomized such that the resulting matrix conforms to good LDPC code performances (e.g., packet error performance). For example, the system can randomize non-zero values of the binary matrix $\Gamma$ (which has a dimension of $(u \times v)$) such that the matrix $\Gamma$ can maintain full rank which equals min (u, v)=24/(1-R), for Wi-Fi error correction codes with a code rate of R. Examples of binary matrix $\Gamma$ are shown in FIG. 8 and FIG. 9, but the present disclosure is not limited thereto and any suitable binary matrix $\Gamma$ can be used to generate a QC-LDPC code. Examples of exponent matrix E(H) and parity check matrix H are shown in FIG. 7A and FIG. 7B, respectively, but the present disclosure is not limited thereto (e.g., not restricted to Wi-Fi error correction code alone) and the techniques according to some embodiments can apply to any generic parity check matrix or its equivalent cyclic representation. In some embodiments, the system can validate a binary $\Gamma$ matrix from a given parity check matrix and a base matrix. For example, the system can validate a binary $\Gamma$ matrix based on performance of the a given parity check matrix and the base matrix. In some embodiments, the binary $\Gamma$ matrix can be any binary matrix $\Gamma$ which are full rank. A matrix (say matrix A) is full rank if the rank of the matrix A is the highest possible for a matrix of the same size as the matrix A.

In some implementations, the system can define (e.g., calculate, compute, obtain, generate) a base code as a parity check matrix H or an exponent matrix P=E(H) as in QC-LDPC code. The system can determine, based on the base code, new code matrices $\acute{H}$ and $\acute{P} = E(\acute{H})$ for QC-LDPC code whose block length is 4 times the block length of the base code, as follows. The system can define the base code having a block length of $n_0$ using $z=z_0$ and the exponent matrix P having a dimension of $(u \times v)$. The system can first calculate a binary matrix $\Gamma_1$ (whose dimension is $(u \times v)$, the same as the dimension of P). The system can then determine (e.g., calculate, compute, obtain) new code matrices $\acute{H}$ and $\acute{P} = E(\acute{H})$ based on the matrices H, P=E(H) and the binary matrix $\Gamma_1$ using Equation 15. The exponent matrix $\acute{P}$ can have a dimension of $(u \times v)$, and the new code based on matrices $\acute{H}$ and $\acute{P} = E(\acute{H})$ can have a block length of $2*n_0$ using $z=2*z_0$. Next, the system can calculate another binary matrix $\Gamma_2$ (whose dimension is $(u \times v)$, the same as the dimension of $\acute{P}$). The system can then determine (e.g., calculate, compute, obtain) new code matrices $\grave{H}$ and $\grave{P} = E(\grave{H})$ based on the matrices $\acute{H}$, $\acute{P} = E(\acute{H})$ and the binary matrix $\Gamma_2$ using Equation 15. The exponent matrix P can have a dimension of $(u \times v)$, and the new code based on matrices $\grave{H}$ and $\grave{P} = E(\grave{H})$ can have a block length of $4*n_0$ using $z=4*z_0$.

In some implementations, the system can define (e.g., calculate, compute, obtain, generate) a base code as a parity check matrix H or an exponent matrix P=E(H) as in QC-LDPC code, and determine new code matrices $\ddot{H}$ and $\ddot{P} = E(\ddot{H})$ for QC-LDPC code whose block length is 4 times the block length of the base code. The system can calculate (e.g., generate, compute, obtain, determine) a binary matrix $\lambda$, which has 4 times the size of P=E(H). For example, if E(H) has a dimension of $(u \times v)$, $\lambda$ has a dimension of $(4u \times 4v)$. The matrix $\lambda$ can internally include sub-matrices which are powers of exchange matrix J(2) and/or one or more zero matrices. The system can determine (e.g., calculate, compute, obtain) new code matrices $\ddot{H}$ and $\ddot{P} = E(\ddot{H})$ using Equation 16 as follows.

$$\ddot{H} = H \circledast \lambda \ldots\ldots\ldots (Equation\ 16).$$

$\ddot{P} = E(\ddot{H})$ can have the same size as that of $\lambda$, and has a dimension of $(4u \times 4v)$. If P=E(H) has a dimension of $(24 \times 24(1-R))$, $\lambda$ will have a dimension of $(96 \times 96(1-R))$. For example, the system can determine new code matrices $\ddot{H}$ and $\ddot{P} = E(\ddot{H})$ for QC-LDPC code (n=7776, k=3888, R=1/2) from the base code (n=1944, k=972, R=1/2) using Equation 16.

Embodiments in the present disclosure have at least the following advantages and benefits.

First, embodiments in the present disclosure can provide useful techniques for providing significant gains across all modulation schemes. For example, the block length (e.g., 7776 bits) of an QC-LDPC code according to some implementations is at least 4 times that of the longest code supported in 802.11n-802.11be standards (e.g., 1994 bits).

Second, codes generated using systems and/or methods according to embodiments in the present disclosure can help in parallel decoding and re-use of several blocks of mother code.

The following IEEE standard(s), including any draft versions of such standard(s), are hereby incorporated herein by reference in their entirety and are made part of the present disclosure for all purposes: WiFi Alliance standards and IEEE 802.11 standards including but not limited to IEEE 802.11a™, IEEE 802.11b™, IEEE 802.11g™, IEEE P802.11n™; IEEE P802.11ac™; and IEEE P802.11be™ through IEEE P802.11bn™ standards. Although this disclosure can reference aspects of these standard(s), the disclosure is in no way limited by these standard(s).

For purposes of reading the description of the various embodiments below, the following descriptions of the sections of the specification and their respective contents can be helpful:

- Section A describes a network environment and computing environment which can be useful for practicing embodiments described herein; and

- Section B describes embodiments of systems and methods for QC-LDPC code with 1/2 code rate.

A. COMPUTING AND NETWORK ENVIRONMENT

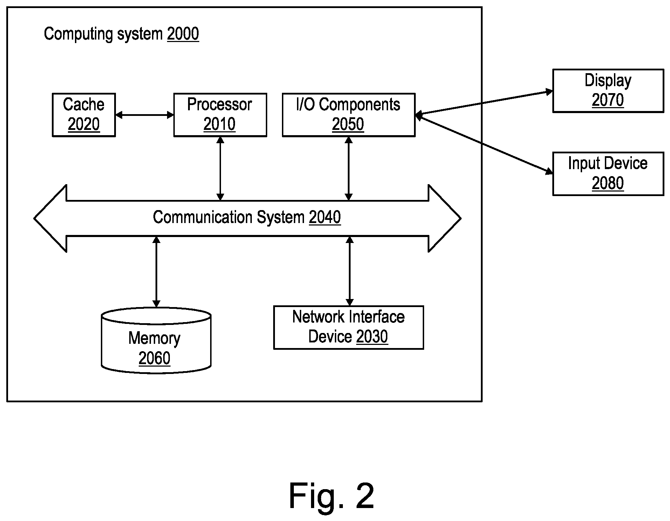

Referring to FIG. 1, illustrated is a diagram depicting an example communication environment 100 including communication systems (or communication apparatuses) 105, 108, according to one or more embodiments. In one embodiment, the communication system 105 includes a baseband circuitry 110 and a transmitter circuitry 120, and the communication system 108 includes a baseband circuitry 150 and a receiver circuitry 140. In one aspect, the communication system 105 is considered a transmitter communication system, and the communication system 108 is considered a receiver communication system. These components operate together to exchange data (e.g., messages or frames) through a wireless medium. These components are embodied as application specific integrated circuit (ASIC), field programmable gate array (FPGA), or any combination of these, in one or more embodiments. In some embodiments, the communication systems 105, 108 include more, fewer, or different components than shown in FIG. 1. For example, each of the communication systems 105, 108 includes transceiver circuitry to allow bi-directional communication between the communication systems 105, 108 or with other communication systems. In some embodiments, each of the communication systems 105, 108 may have configuration similar to that of a computing system 2000 as shown in FIG. 2.

The baseband circuitry 110 of the communication system 105 is a circuitry that generates the baseband data 115 for transmission. The baseband data 115 includes information data (e.g., signal(s)) at a baseband frequency for transmission. In one approach, the baseband circuitry 110 includes an encoder 130 that encodes the data, and generates or outputs parity bits. In one aspect, the baseband circuitry 110 (or encoder 130) obtains a generator matrix or a parity check matrix, or uses a previously produced generator matrix or a previously produced parity check matrix, and encodes the information data by applying the information data to the generator matrix or the parity check matrix to obtain a codeword. In some embodiments, the baseband circuitry 110 stores one or more generator matrices or one or more parity check matrices that conform to any IEEE 802.11 standard for WLAN communication. The baseband circuitry 110 retrieves the stored generator matrix or the stored parity check matrix in response to detecting information data to be transmitted, or in response to receiving an instruction to encode the information data. In one approach, the baseband circuitry 110 generates the parity bits according to a portion of the generator matrix or using the parity check matrix, and appends the parity bits to the information bits to form a codeword. The baseband circuitry 110 generates the baseband data 115 including the codeword for the communication system 108, and provides the baseband data 115 to the transmitter circuitry 120.

The transmitter circuitry 120 of the communication system 105 includes or corresponds to a circuitry that receives the baseband data 115 from the baseband circuitry 110 and transmits a wireless signal 125 according to the baseband data 115. In one configuration, the transmitter circuitry 120 is coupled between the baseband circuitry 110 and an antenna (not shown). In this configuration, the transmitter circuitry 120 up-converts the baseband data 115 from the baseband circuitry 110 onto a carrier signal to generate the wireless signal 125 at an RF frequency (e.g., 10 MHz to 60 GHz), and transmits the wireless signal 125 through the antenna.

The receiver circuitry 140 of the communication system 108 is a circuitry that receives the wireless signal 125 from the communication system 105 and obtains baseband data 145 from the received wireless signal 125. In one configuration, the receiver circuitry 140 is coupled between the baseband circuitry 150 and an antenna (not shown). In this configuration, the receiver circuitry 140 receives the wireless signal 125 though an antenna, and down-converts the wireless signal 125 at an RF frequency according to a carrier signal to obtain the baseband data 145 from the wireless signal 125. The receiver circuitry 140 then provides the baseband data 145 to the baseband circuitry 150.

The baseband circuitry 150 of the communication system 108 includes or corresponds to a circuitry that receives the baseband data 145 from the receiver circuitry 140 and obtains information data from the received baseband data 145. In one embodiment, the baseband circuitry 150 includes a decoder 160 that extracts information and parity bits from the baseband data 145. The decoder 160 decodes the baseband data 145 to obtain the information data generated by the baseband circuitry 110 of the communication system 105.

In some embodiments, each of the baseband circuitry 110 (including the encoder 130), the transmitter circuitry 120, the receiver circuitry 140, and the baseband circuitry 150 (including the decoder 160) may be as one or more processors, application specific integrated circuit (ASIC), field programmable gate array (FPGA), or any combination of them.

FIG. 2 is a schematic block diagram of a computing system, according to an embodiment. An illustrated example computing system 2000 includes one or more processors 2010 in direct or indirect communication, via a communication system 2040 (e.g., bus), with memory 2060, at least one network interface controller 2030 with network interface port for connection to a network (not shown), and other components, e.g., input/output ("I/O") components 2050. Generally, the processor(s) 2010 will execute instructions (or computer programs) received from memory. The processor(s) 2010 illustrated incorporate, or are connected to, cache memory 2020. In some instances, instructions are read from memory 2060 into cache memory 2020 and executed by the processor(s) 2010 from cache memory 2020. The computing system 2000 may not necessarily contain all of these components shown in FIG. 2, and may contain other components that are not shown in FIG. 2.

In more detail, the processor(s) 2010 may be any logic circuitry that processes instructions, e.g., instructions fetched from the memory 2060 or cache 2020. In many implementations, the processor(s) 2010 are microprocessor units or special purpose processors. The computing device 2050 may be based on any processor, or set of processors, capable of operating as described herein. The processor(s) 2010 may be single core or multi-core processor(s). The processor(s) 2010 may be multiple distinct processors.

The memory 2060 may be any device suitable for storing computer readable data. The memory 2060 may be a device with fixed storage or a device for reading removable storage media. Examples include all forms of volatile memory (e.g., RAM), non-volatile memory, media and memory devices, semiconductor memory devices (e.g., EPROM, EEPROM, SDRAM, and flash memory devices), magnetic disks, magneto optical disks, and optical discs (e.g., CD ROM, DVD-ROM, or Blu-Ray® discs). A computing system 2000 may have any number of memory devices 2060.

The cache memory 2020 is generally a form of computer memory placed in close proximity to the processor(s) 2010 for fast read times. In some implementations, the cache memory 2020 is part of, or on the same chip as, the processor(s) 2010. In some implementations, there are multiple levels of cache 2020, e.g., L2 and L3 cache layers.

The network interface controller 2030 manages data exchanges via the network interface (sometimes referred to as network interface ports). The network interface controller 2030 handles the physical and data link layers of the OSI model for network communication. In some implementations, some of the network interface controller's tasks are handled by one or more of the processor(s) 2010. In some implementations, the network interface controller 2030 is part of a processor 2010. In some implementations, the computing system 2000 has multiple network interfaces controlled by a single controller 2030. In some implementations, the computing system 2000 has multiple network interface controllers 2030. In some implementations, each network interface is a connection point for a physical network link (e.g., a cat-5 Ethernet link). In some implementations, the network interface controller 2030 supports wireless network connections and an interface port is a wireless (e.g., radio) receiver or transmitter (e.g., for any of the IEEE 802.11 protocols, near field communication "NFC", Bluetooth, ANT, or any other wireless protocol). In some implementations, the network interface controller 2030 implements one or more network protocols such as Ethernet. Generally, a computing device 2050 exchanges data with other computing devices via physical or wireless links through a network interface. The network interface may link directly to another device or to another device via an intermediary device, e.g., a network device such as a hub, a bridge, a switch, or a router, connecting the computing device 2000 to a data network such as the Internet.

The computing system 2000 may include, or provide interfaces for, one or more input or output ("I/O") devices. Input devices include, without limitation, keyboards, microphones, touch screens, foot pedals, sensors, MIDI devices, and pointing devices such as a mouse or trackball. Output devices include, without limitation, video displays, speakers, refreshable Braille terminal, lights, MIDI devices, and 2-D or 3-D printers.

Other components may include an I/O interface, external serial device ports, and any additional co-processors. For example, a computing system 2000 may include an interface (e.g., a universal serial bus (USB) interface) for connecting input devices, output devices, or additional memory devices (e.g., portable flash drive or external media drive). In some implementations, a computing device 2000 includes an additional device such as a co-processor, e.g., a math co-processor can assist the processor 2010 with high precision or complex calculations.

The components 2090 may be configured to connect with external media, a display 2070, an input device 2080 or any other components in the computing system 2000, or combinations thereof. The display 2070 may be a liquid crystal display (LCD), an organic light emitting diode (OLED) display, a flat panel display, a solid state display, a cathode ray tube (CRT) display, a projector, a printer or other now known or later developed display device for outputting determined information. The display 2070 may act as an interface for the user to see the functioning of the processor(s) 2010, or specifically as an interface with the software stored in the memory 2060.

The input device 2080 may be configured to allow a user to interact with any of the components of the computing system 2000. The input device 2080 may be a plurality pad, a keyboard, a cursor control device, such as a mouse, or a joystick. Also, the input device 2080 may be a remote control, touchscreen display (which may be a combination of the display 2070 and the input device 2080), or any other device operative to interact with the computing system 2000, such as any device operative to act as an interface between a user and the computing system 2000.

## B. SYSTEMS AND METHODS FOR QC-LDPC CODE WITH 1/2 CODE RATE

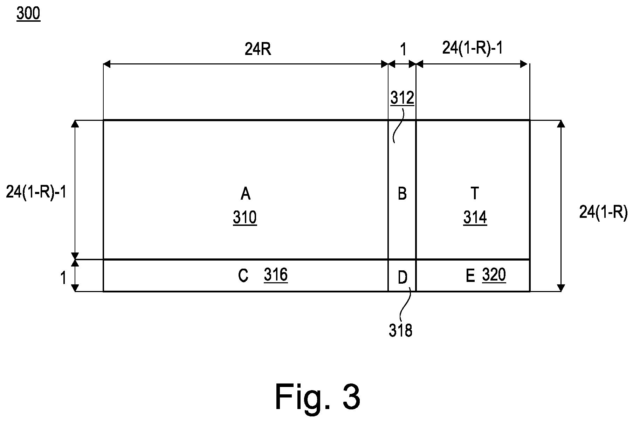

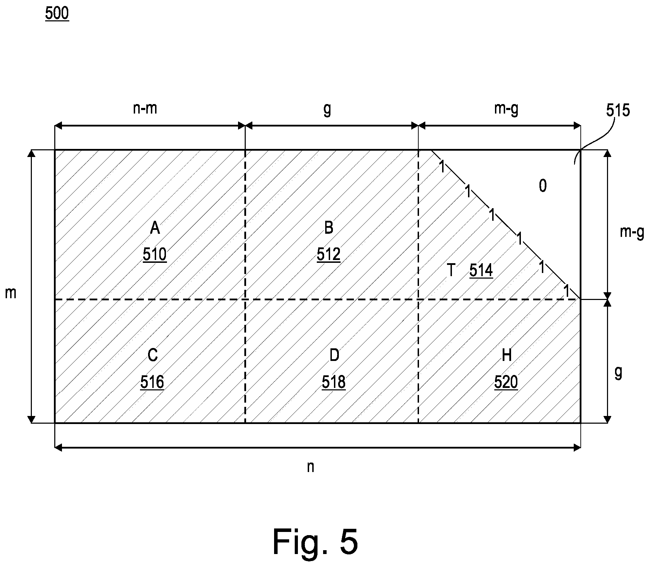

FIG. 3 is a diagram depicting an example exponent matrix (QC-LDPC exponent matrix) 300, according to one or more embodiments. Given a lifting size z, the exponent matrix 300 may have a size of m/z x n/z. If n=24z (e.g., n=7776, z=324), then the size of P=E(H) is 24(1-R) x 24 (= n(1-R)/z x n/z). Elements of the exponent matrix may be integer values which correspond to cyclic shift values of identity matrix of size z x z. A parity check matrix H (see FIG. 5) may be a sparse binary matrix that can be derived from an exponent matrix P=E(H). The generator matrix G may have a size n x k in binary form (e.g., elements of the generator matrix G are binary values). Referring to FIG. 3, the exponent matrix P=E(H) may have a structure including a plurality of sub-matrices (e.g., A 310, B 312, C 316, D 318, E 320, T 314).

FIG. 4 is a diagram 400 depicting example shifted identity matrices 409, 410, 411, 412, 413, 414, 415, 416 for generating a parity check matrix, according to one or more embodiments. A parity check matrix H may be generated from an exponent matrix P=E(H) (e.g., exponent matrix 300) or may be identified using a codebook. As shown in Equation 7, the exponent matrix P=E(H) may include (as elements) shift values d in the range 0<=d<z along with d=-1. See Equation For example, if z=7, the shift values d may include -1, 0, 1, 2, 3, 4, 5, 6 (see FIG. 4). The shift value d=0 may correspond (or map) to an identity matrix of size z x z, denoted by I(z) (e.g., matrix 410). The shift value d=-1 may correspond (or map) to a null matrix (all elements zero) of size z x z, denoted by 0*I(z) (e.g., matrix 409). Any other integer value d in [1,z-1] may correspond (or map) to a matrix cyclically right shifted from I(z) (e.g., matrices 411, 412, 413, 414, 415, 416). As shown in Equation 8, the parity check matrix H can be obtained from the exponent matrix P=E(H) by expanding the exponent matrix P such that each element of the exponent matrix P (as a shift value d) is replaced by a matrix corresponding to the shift value.

FIG. 5 is a diagram depicting an example parity check matrix 500, according to one or more embodiments. In some implementations, an encoder (e.g., encoder 130) can produce codewords using a generator matrix (e.g., using Equation 2). In some implementations, an encoder (e.g., encoder 130) can use the parity check matrix (rather than the generator matrix) to produce codewords from vectors of information bits. After a parity check matrix H is obtained (e.g., using a codebook), the parity check matrix H (e.g., parity check matrix 500) may have sub-matrices A 510, B 512, C 516, D 518, T 514, E 520. An upper area O 515 of the sub-matrix T 514 (e.g., white area in FIG. 5) may correspond to an area in which the matrix contains all zeroes, and the other areas (e.g., grey area in FIG. 5) may represent locations that can contain ones. The size of the parity check matrix 500 may be m x n where the size of the sub-matrix D 518 is g x g, and the size of the sub-matrix T is (m-g)x(m-g). In some implementations, given a vector s of information bits to be encoded, the encoder can obtain a codeword c using Equation 10, Equation 11, Equation 12 and Equation 13.

In some implementations, a codebook for R=1/2 LDPC code of blocklength=7776 bits can provide high performance error correction and/or provide up to 0.5-2dB gain over existing LDPC codes (e.g., 3888 length codes). In some implementations, a collection of LDPC codes with a block length of 7776 bits (4x1944), supporting all the code rates in a Wi-Fi standard (e.g., 802.11be). The code (e.g., R=1/2 LDPC code of blocklength=7776 bits) can be directly used in an existing modulation of 64-QAM in the IEEE 802.11be and potentially in combination with more combinations of QAM sizes in the IEEE 802.bn.

In some implementations, a codebook for R=1/2 LDPC code of blocklength=7776 bits can be directly used in an existing modulation as in existing modulation scheme like binary phase-shift keying (BPSK), quadrature phase-shift keying (BPSK), 16-QAM, 64-QAM, 256-QAM, 1024-QAM, and 4096-QAM, as seen in standards such as IEEE 802.11be or IEEE 802.11bn. Moreover, a codebook for R=1/2 LDPC code of blocklength=7776 bits can have the potential to be employed in conjunction with one or more combinations of QAM sizes, whether similar or different, across OFDMA resource units (RU), distributed RU (DRU), punctured RUs (MRU), within a single stream and or across multiple spatial streams, as provisioned in MIMO configurations.

The collection of LDPC codes with a block length of 7776 bits (4x1944) can deliver considerable performance improvements in various communication scenarios in ultra high reliability (UHR), while maintaining manageable complexity. Performance comparisons are conducted between these codes and LDPC codes specified in the IEEE 802.11be standards, as well as recently proposed codes with a block length of 4x1944. Results of the performance comparisons show demonstrable gains across the board (e.g., channels, PHY bandwidth, MIMO, modulation coding scheme (MCS), Transmit Beamforming). For example, LDPC codes with a block length of 7776 bits according to some implementations can provides 0.5-2dB gains over the present 802.11 LDPC codes (e.g., 3888 length codes), depending on channel conditions.

The longest LDPC codes specified in 802.11be standards have block length=1944 bits. Performance wise, the LDPC codes specified in 802.11be standards are about 2.7dB away from the optimum random codes (e.g., bit-interleaved coded modulation (BICM)-additive white Gaussian noise (AWGN)-QAM (Quadrature Amplitude Modulation) R=1/2 limits). Longer blocklength random codes (e.g., the Shannon limit deals with the asymptotic case when the blocklength grows unboundedly large) can lead to enhanced coding gains, in accordance with the finite-length scaling laws. Deterministic codes, which are suboptimal, can exhibit scaling gains that are significantly larger than those of optimal random codes. For example, in AWGN a doubling effect is known to be true.

In some implementations, LDPC codes with blocklength=4x1944=7776 bits (which double the size of maximum supported blocklength in the present 802.11be standards). In some implementations, LDPC codes with blocklength=7776 bits can support all the existing code rates (e.g., R=1/2, 2/3, 3/4 and 5/6). In some implementations, LDPC codes with blocklength=7776 bits can keep the structure of the 802.11be code, QC-LDPC specifically, unchanged, except for the matrix size expansion. This adaptation can facilitate the reutilization of existing implementations and to empower concurrent encoding and decoding functionalities.

FIG. 6 is a diagram depicting an example exponent matrix (QC-LDPC exponent matrix) 600, according to one or more embodiments. Given a lifting size z, the exponent matrix 600 may have a size of m/z x n/z. If n=96z (e.g., n=7776, z=81), then the size of P=E(H) matrix for n=7776 is 96(1-R) x 96 (= n(1-R)/z x n/z). Elements of the exponent matrix may be integer values which correspond to cyclic shift values of identity matrix of size z x z. A parity check matrix H may be a sparse binary matrix that can be derived from an exponent matrix P=E(H). The generator matrix G may have a size n x k in binary form (e.g., elements of the generator matrix G are binary values). Referring to FIG. 6, the exponent matrix P=E(H) may have a structure including a plurality of sub-matrices (e.g., Á 610, Ɓ 612, Ć 616, Ɗ 618, É 620, Ŧ 614).

FIG. 7A, FIG. 7B and FIG. 7C are diagrams depicting an example exponent matrix and example binary parity check matrices, according to one or more embodiments. A system according to some implementations can define, generate, or create a new Quasi Cyclic (QC)-LDPC codebook of blocklength n = 7776 bits, rate R= 1/2, and information length k = 1/2*7776 =3888 bits. For example, the system can define, generate, or create a parity check matrix H (e.g., parity check matrix 750 in FIG. 7B or parity check matrix 780 in FIG. 7C) which has size = (1-R)*n x n = 1296 x 7776. The system can define, generate, or create an exponent matrix E(H) (e.g., exponent matrix 700 in FIG. 7A) which is equivalent to H. E(H) has size 96*(1-R) x 96 and contains cyclic shift values such that each of the entries gets mapped to circulant matrix of size Z=81 (see FIG. 6). Elements of E(H) are integers between -1 and Z-1 (Z=81). For example, as shown in FIG. 7A, the exponent matrix E(H) includes the following values: [-1 -1 -1 57 -1 -1 -1 -1 -1 -1 -1 -1 -1 -1 -1 -1 -1 -1 -1 50 -1 -1 -1 -1 -1 11 -1 -1 -1 -1 -1 -1 -1 50 -1 -1 -1 -1 -1 -1 -1 79 -1 -1 -1 -1 -1 11 -1 -1 -1 0 -1 -1 -1 -1 -1 -1 -1 -1 -1 -1 -1 -1 -1 -1 -1 -1 -1 -1 -1 -1 -1 -1 -1 -1 -1 -1 -1 -1 -1 -1 -1 -1 -1 -1 -1 -1 -1 -1 -1 -1 -1 -1 -1 -1 -1 -1 -1 57 -1 -1 -1 -1 -1 -1 -1 -1 -1 -1 -1 -1 50 -1 -1 -1 -1 11 -1 -1 -1 -1 -1 -1 -1
-1 50 -1 -1 -1 -1 -1 -1 -1 -1 79 -1 -1 -1 -1 -1 11 -1 -1 -1 0 -1 -1 -1 -1 -1 -1 -1 -1 -1 -1 -1 -1 -1 -1 -1 -1 -1 -1 -1 -1 -1 -1 -1 -1 -1 -1 -1 -1 -1 -1 -1 -1 -1 -1 -1 -1 -1 -1 -1 -1
-1 -1 -1 -1 -1 -1 -1 -1 -1 -1 -1 -1 -1 -1 -1 -1 -1 57 -1 -1 -1 -1 -1 -1 -1 -1 -1 -1 -1 -1 -1 -1 50 -1 -1 -1 -1 11 -1 -1 -1 -1 -1 -1 -1
-1 50 -1 -1 -1 -1 -1 -1 -1 -1 79 -1 -1 -1 -1 -1 11 -1 -1 -1 0 -1 -1 -1 -1 -1 -1 -1 -1 -1 -1 -1 -1 -1 -1 -1 -1 -1 -1 -1 -1 -1 -1 -1 -1 -1 -1 -1 -1 -1 -1 -1 -1 -1 -1 -1 -1 -1 -1 -1 -1
-1 -1 -1 -1 -1 -1 -1 57 -1 -1 -1 -1 -1 -1 -1 -1 -1 -1 -1 -1 -1 50 -1 -1 -1 -1 -1 -1 -1 11 -1 -1 -1 -1 -1 -1 -1 50 -1 -1 -1 -1
79 -1 -1 -1 -1 -1 -1 -1 -1 11 -1 -1 -1 0 -1 -1 -1 -1 -1 -1 -1 -1 -1 -1 -1 -1 -1 -1 -1 -1 -1 -1 -1 -1 -1 -1 -1 -1 -1 -1 -1 -1 -1 -1 -1 -1 -1 -1 -1 -1 -1 -1 -1 -1 -1 -1 -1 -1 -1 -1
-1 -1 13 -1 -1 -1 -1 -1 -1 -1 128 -1 -1 -1 -1 -1 10 -1 -1 -1 -1 -1 -1 -1 -1 -1 -1 -1 -1 155 -1 -1 -1 -1 -1 17 -1 -1 -1 -1 -1 -1 -1 -1 -1 -1
-1 10 -1 -1 -1 10 -1 -1 -1 -1 -1 -1 -1 -1 -1 -1 -1 -1 -1 -1 -1 -1 -1 -1 -1 -1 -1 -1 -1 -1 -1 -1 -1 -1 -1 -1 -1 -1 -1 -1 -1 -1 -1 -1 -1 -1 -1 -1 3 -1 -1
-1 -1 -1 -1 128 -1 -1 -1 -1 -1 -1 10 -1 -1 -1 -1 -1 -1 -1 -1 -1 -1 -1 -1 -1 155 -1 -1 -1 17 -1 -1 -1 -1 -1 -1 -1 -1 -1 -1 -1 -1 -1 10 -1 -1 -1 0
-1 -1 -1 -1 -1 -1 -1 -1 -1 -1 -1 -1 -1 -1 -1 -1 -1 -1 -1 -1 -1 -1 -1 -1 -1 -1 -1 -1 -1 -1 -1 -1 -1 -1 13 -1 -1 -1 -1 -1 -1 -1 128 -1 -1
-1 -1 -1 10 -1 -1 -1 -1 -1 -1 -1 -1 -1 -1 -1 -1 -1 -1 -1 -1 155 -1 17 -1 -1 -1 -1 -1 -1 -1 -1 -1 -1 -1 -1 -1 -1 -1 -1 10 -1 -1 -1 0 -1 -1 -1 -1
-1 -1 -1 -1 -1 -1 -1 -1 -1 -1 -1 -1 -1 -1 -1 -1 -1 -1 -1 -1 -1 -1 -1 -1 -1 -1 -1 13 -1 -1 -1 -1 128 -1 -1 -1 -1 -1 -1 -1 10
-1 -1 -1 -1 -1 -1 -1 -1 -1 -1 -1 -1 -1 -1 -1 155 7 -1 -1 -1 -1 -1 -1 -1 -1 -1 -1 -1 -1 -1 -1 -1 -1 -1 10 -1 -1 -1 10 -1 -1 -1 -1 -1 -1 -1 -1 -1
-1 -1 -1 -1 -1 -1 -1 -1 -1 -1 -1 -1 -1 -1 -1 -1 -1 -1 -1 -1 -1 -1 -1 -1 -1 -1 -1 -1 130 -1 -1 -1 -1 -1 -1 -1 -1 -1 -1 -1 -1 -1 -1 124 37 -1
-1 -1 -1 -1 -1 -1 -1 -1 -1 156 -1 -1 -1 -1 -1 -1 114 -1 -1 -1 -1 -1 -1 -1 -1 -1 -1 -1 -1 -1 10 -1 -1 10 -1 -1 -1 -1 -1 -1 -1 -1 -1 -1 -1 -1
-1 -1 -1 -1 -1 -1 -1 -1 -1 -1 -1 -1 -1 -1 -1 -1 -1 -1 -1 -1 -1 -1 -1 130 -1 -1 -1 -1 -1 -1 -1 -1 -1 -1 -1 -1 -1 24 -1 -1 37 -1 -1 -1
-1 -1 -1 -1 -1 -1 -1 156 -1 -1 -1 -1 114 -1 -1 -1 -1 -1 -1 -1 -1 -1 -1 -1 -1 -1 -1 -1 -1 -1 10 -1 -1 10 -1 -1 -1 -1 -1 -1 -1 -1 -1 -1 -1 -1
-1 -1 -1 -1 -1 -1 -1 -1 -1 -1 -1 -1 -1 -1 -1 -1 -1 -1 130 -1 -1 -1 -1 -1 -1 -1 -1 -1 -1 -1 -1 -1 -1 124 -1 -1 -1 -1 37 -1 -1 -1 -1 -1 -1
-1 -1 -1 -1 156 -1 114 -1 -1 -1 -1 -1 -1 -1 -1 -1 -1 -1 -1 -1 -1 -1 -1 10 -1 -1 10 -1 -1 -1 -1 -1 -1 -1 -1 -1 -1 -1 -1 -1 -1 -1 -1 -1 -1 -1
-1 -1 -1 -1 -1 -1 -1 -1 -1 -1 -1 -1 -1 130 -1 -1 -1 -1 -1 -1 -1 -1 -1 -1 -1 -1 124 -1 -1 -1 -1 -1 37 -1 -1 -1 -1 -1 -1 -1 -1
-1 -1 156 14 -1 -1 -1 -1 -1 -1 -1 -1 -1 -1 -1 -1 -1 -1 -1 -1 -1 10 -1 -1 10 -1 -1 -1 -1 -1 -1 -1 -1 -1 -1 -1 -1 -1 -1 -1 -1 -1
-1 -1 -1 -1 -1 -1 -1 -1 -1 -1 -1 -1 -1 62 -1 -1 -1 53 -1 -1 -1 -1 -1 -1 -1 -1 -1 -1 -1 -1 -1 53 -1 -1 -1 -1 -1 -1 13 -1 -1 -1 35 -1 -1 -1
-1 -1 -1 -1 -1 -1 -1 -1 -1 -1 -1 -1 -1 -1 -1 -1 -1 -1 -1 10 -1 -1 10 -1 -1 -1 -1 -1 -1 -1 -1 -1 -1 -1 -1 -1 -1 -1 -1 -1 -1 -1 -1 -1 -1
-1 -1 -1 -1 -1 -1 -1 -1 -1 62 -1 -1 -1 53 -1 -1 -1 -1 -1 -1 -1 -1 -1 -1 -1 53 -1 -1 -1 -1 -1 -1 -1 -1 13 -1 -1 -1 35 -1 -1 -1 -1 -1 -1 -1
-1 -1 -1 -1 -1 -1 -1 -1 -1 -1 -1 -1 -1 -1 -1 -1 -1 10 -1 -1 10 -1 -1 -1 -1 -1 -1 -1 -1 -1 -1 -1 -1 -1 -1 -1 -1 -1 -1 -1 -1 -1 -1 -1 -1 -1
-1 -1 -1 -1 -1 62 -1 -1 53 -1 -1 -1 -1 -1 -1 -1 -1 -1 53 -1 -1 -1 -1 -1 -1 -1 -1 -1 13 -1 -1 -1 35 -1 -1 -1 -1 -1 -1 -1 -1 -1 -1 -1 -1 -1
-1 -1 -1 -1 -1 -1 -1 -1 -1 -1 -1 -1 -1 -1 -1 10 -1 -1 10 -1 -1 -1 -1 -1 -1 -1 -1 -1 -1 -1 -1 -1 -1 -1 -1 -1 -1 -1 -1 -1 -1 -1 -1 -1 -1 -1
-1 62 -1 -1 53 -1 -1 -1 -1 -1 -1 -1 -1 -1 -1 53 -1 -1 -1 -1 -1 -1 -1 -1 13 -1 -1 -1 35 -1 -1 -1 -1 -1 -1 -1 -1 -1 -1 -1 -1 -1 -1 -1 -1 -1
-1 -1 -1 -1 -1 -1 -1 -1 -1 -1 -1 -1 10 -1 -1 10 -1 -1 -1 -1 -1 -1 -1 -1 -1 -1 -1 -1 -1 -1 -1 -1 -1 -1 -1 -1 -1 -1 -1 -1 -1 -1 -1 -1 -1
-1 62 -1 -1 53 -1 -1 -1 -1 -1 -1 15 3 -1 -1 -1 -1 -1 -1 -1 -1 -1 -1 -1 13 -1 -1 -1 35 -1 -1 -1 -1 -1 -1 -1 -1 -1 -1 -1 -1 -1 -1
-1 -1 -1 -1 -1 -1 -1 -1 -1 -1 -1 -1 10 -1 -1 10 -1 -1 -1 -1 -1 -1 -1 -1 -1 -1 -1 -1 -1 -1 -1 -1 -1 -1 -1 -1 -1 -1 -1 -1 -1 -1 -1 -1 -1 -1 40
-1 -1 -1 -1 -1 -1 -1 20 -1 -1 -1 66 -1 -1 -1 -1 -1 -1 -1 -1 -1 -1 22 -1 -1 28 -1 -1 -1 -1 -1 -1 -1 -1 -1 -1 -1 -1 -1 -1 -1 -1 -1 -1 -1 -1
-1 -1 -1 -1 -1 -1 -1 10 -1 -1 10 -1 -1 -1 -1 -1 -1 -1 -1 -1 -1 -1 -1 -1 -1 -1 -1 -1 -1 -1 -1 -1 -1 -1 40 -1 -1 -1 -1
-1 -1 -1 -1 -1 20 -1 -1 66 -1 -1 -1 -1 -1 -1 -1 -1 -1 -1 22 -1 -1 28 -1 -1 -1 -1 -1 -1 -1 -1 -1 -1 -1 -1 -1 -1 -1 -1 -1 -1 -1 -1
-1 -1 -1 -1 -1 -1 -1 10 -1 -1 10 -1 -1 -1 -1 -1 -1 -1 -1 -1 -1 -1 -1 -1 -1 -1 -1 -1 -1 -1 40 -1 -1 -1 -1 -1 -1 -1 -1
-1 -1 -1 20 -1 -1 -1 66 -1 -1 -1 -1 -1 -1 -1 22 -1 -1 28 -1 -1 -1 -1 -1 -1 -1 -1 -1 -1 -1 -1 -1 -1 -1 -1 -1 -1 -1 -1 -1 -1
-1 -1 -1 -1 -1 -1 10 -1 -1 10 -1 -1 -1 -1 -1 -1 -1 -1 -1 -1 -1 -1 -1 -1 -1 -1 40 -1 -1 -1 -1 -1 -1 -1 -1 -1 -1 -1 20 -1 -1 66 -1 -1 -1 -1 -1 -1 -1 -1 -1 22 -1 -1 -1 28 -1 -1 -1 -1 -1 -1 -1 -1 -1 -1 -1 -1 -1 -1 -1 -1 -1 -1 -1 -1 -1 -1 -1 -1 -1 -1 -1 -1 -1 -1 -1 0 -1 -1 -1 0 -1 -1 -1 -1 -1 -1 -1 -1 -1 -1 -1 -1 -1 -1 -1 -1 -1 -1 -1 -1 -1 0 -1 -1 -1 -1 -1 -1 -1 -1 -1 -1 -1 -1 -1 -1 -1 8 -1 -1 -1 -1 -1 42 -1 -1 -1 -1 -1 -1 -1 -1 -1 50 -1 -1 -1 -1 -1 -1 -1 18 -1 -1 -1 -1 -1 -1 -1 -1 -1 -1 -1 -1 -1 -1 -1 -1 -1 -1 -1 -1 10 -1 -1 -1 0 -1 -1 -1 -1 -1 -1 -1 -1 -1 -1 -1 -1 -1 -1 -1 -1 -1 -1 -1 -1 -1 0 -1 -1 -1 -1 -1 -1 -1 -1 -1 -1 -1 -1 -1 -1 -1 -1 8 -1 -1 -1 -1 -1 -1 1 -1 42 -1 -1 -1 -1 -1 -1 -1 -1 50 -1 -1 -1 -1 -1 -1 -1 18 -1 -1 -1 -1 -1 -1 -1 -1 -1 -1 -1 -1 -1 -1 -1 -1 -1 -1 -1 -1 -1 -1 -1 10 -1 -1 -1 0 -1 -1 -1 -1 -1 -1 -1 -1 -1 -1 -1 -1 -1 -1 -1 -1 -1 -1 -1 -1 0 -1 -1 -1 -1 -1 -1 -1 -1 -1 -1 -1 -1 -1 18 -1 -1 -1 -1 -1 -1 1 42 -1 -1 -1 -1 -1 -1 -1 -1 50 -1 -1 -1 -1 -1 -1 -1 18 -1 -1 -1 -1 -1 -1 -1 -1 -1 -1 -1 -1 -1 -1 -1 -1 -1 -1 -1 -1 -1 -1 -1 10 -1 -1 10 -1 -1 -1 -1 -1 -1 -1 -1 -1 -1 -1 -1 -1 -1 -1 -1 -1 -1 -1 -1 -1 -1 0 -1 -1 -1 -1 -1 -1 -1 -1 -1 -1 -1 -1 -1 -1 -1 18 -1 -1 -1 -1 -1 -1 1 42 -1 -1 -1 50 -1 -1 -1 -1 -1 -1 -1 -1 -1 18 -1 -1 -1 -1 -1 -1 -1 -1 -1 -1 -1 -1 -1 -1 -1 -1 -1 -1 -1 -1 -1 -1 -1 10 -1 -1 10 -1 -1 -1 -1 -1 -1 -1 -1 -1 -1 -1 -1 -1 -1 -1 -1 -1 -1 -1 -1 -1 -1 -1 -1 -1 -1 -1 -1 18 -1 -1 -1 -1 -1 -1 1

-1 -1 -1 -1 -1 -1 -1 -1 -1 -1 18 -1 -1 -1 -1 -1 -1 -1 -1 -1 -1 -1 -1 -1 -1 -1 -1 -1 -1 -1 -1 -1 -1 -1 -1 -1 -1 -1 -1 -1 10 -1 -1 10 -1 -1 -1 -1 -1 -1 -1 -1 -1 -1 -1 -1 -1 -1 -1 -1 -1 -1 -1 -1 -1 -1 -1 -1 -1 -1 -1 -1 -1 69 -1 -1 79 -1 -1 -1 -1 79 -1 -1 -1 -1 -1 -1 -1 -1 -1 -1 -1 -1 -1 -1 -1 -1 -1 -1 56 -1 -1 -1 -1 -1 52 -1 -1 -1 -1 -1 -1 -1 -1 -1 -1 -1 -1 -1 -1 -1 -1 -1 10 -1 -1 -1 -1 -1 -1 -1 -1 -1 -1 -1 -1 -1 -1 -1 -1 -1 -1 -1 -1 -1 -1 -1 10 -1 -1 10 -1 -1 -1 -1 -1 -1 -1 -1 -1 -1 -1 -1 -1 -1 -1 -1 -1 69 -1 -1 -1 79 -1 -1 79 -1 -1 -1 -1 -1 -1 -1 -1 -1 -1 -1 -1 -1 -1 -1 -1 -1 -1 56 -1 -1 -1 52 -1 -1 -1 -1 -1 -1 -1 -1 -1 - 1 -1 -1 -1 -1 -1 10 -1 -1 -1 -1 -1 -1 -1 -1 -1 -1 -1 -1 -1 -1 -1 -1 -1 -1 -1 -1 10 -1 -1 10 -1 -1 -1 -1 -1 -1 -1 -1 -1 -1 -1 -1 -1 -1 -1 -1 -1 69 -1 -1 79 -1 -1 -1 -1 79 -1 -1 -1 -1 -1 -1 -1 -1 -1 -1 -1 -1 -1 -1 -1 56 -1 -1 -1 -1 -1 -1 -1 52 -1 -1 -1 -1 -1 -1 -1 -1 -1 -1 -1 -1 -1 -1

-1 -1 -1 10 -1 -1 -1 -1 -1 -1 -1 -1 -1 -1 -1 -1 -1 -1 -1 -1 -1 -1 -1 -1 -1 10 -1 -1 10 -1 -1 -1 -1 -1 -1 -1 -1 -1 -1 -1 -1 -1 -1 -1 -1 -1 -1 -1 69 -1 -1 -1 79 -1 -1 79 -1 -1 -1 -1 -1 -1 -1 -1 -1 -1 -1 -1 -1 -1 -1 56 -1 -1 -1 -1 -1 -1 52 -1 -1 -1 -1 -1 -1 -1 -1 -1 -1 -1 -1 -1 -1 -1 -1 0 -1 -1 -1 -1 -1 -1 -1 -1 -1 -1 -1 -1 -1 -1 -1 -1 -1 -1 10 -1 -1 10 -1 -1 -1 -1 -1 -1 -1 -1 -1 -1 -1 -1 -1 -1 -1 -1 -1 -1 65 -1 -1 -1 -1 -1 -1 -1 -1 -1 -1 -1 -1 -1 38 -1 -1 57 -1 -1 -1 -1 -1 -1 -1 -1 -1 -1 72 -1 -1 -1 -1 -1 -1 27 -1 -1 -1 -1 -1 -1 -1 -1 -1 -1 -1 -1 -1 -1 -1 -1 -1 -1 -1 -1 -1 -1 -1 -1 -1 -1 -1 -1 10 -1 -1 10 -1 -1 -1 -1 -1 -1 -1 -1 -1 -1 -1 -1 -1 -1 -1 -1 65 -1 -1 -1 -1 -1 -1 -1

-1 -1 -1 -1 -1 -1 38 -1 -1 -1 57 -1 -1 -1 -1 -1 -1 -1 -1 -1 72 -1 -1 -1 -1 -1 27 -1 -1 -1 -1 -1 -1 -1 -1 -1 -1 -1 -1 -1 -1 -1 -1 -1 -1 -1 -1 -1 -1 10 -1 -1 10 -1 -1 -1 -1 -1 -1 -1 -1 -1 -1 -1 -1 -1 -1 -1 65 -1 -1 -1 -1 -1 -1 -1 -1 -1 -1 -1 38 -1 -1 57 -1 -1 -1 -1 -1 -1 -1 -1 -1 -1 72 -1 -1 -1 -1 -1 27 -1 -1 -1 -1 -1 -1 -1 -1 -1 -1 -1 -1 -1 -1 -1 -1 -1 -1 -1 -1 -1 -1 -1 10 -1 -1 10 -1 -1 -1 -1 -1 -1 -1 -1 -1 -1 -1 -1 -1 65 -1 -1 -1 -1 -1 -1 -1 -1 38 -1 -1 -1 57 -1 -1 -1 -1 -1 -1 -1 -1 -1 72 -1 -1 -1 -1 -1 27 -1 -1 -1 -1 -1 -1 -1 -1 -1 -1 -1 -1 -1 -1 -1 -1 -1 -1 -1 -1

-1 -1 -1 -1 -1 -1 -1 -1 -1 -1 -1 -1 10 -1 -1 10 -1 -1 -1 -1 -1 -1 -1 -1 -1 -1 -1 -1 -1 64 -1 -1 -1 -1 -1 -1 -1 -1 -1 114 -1 -1 -1 52 -1 -1 -1 -1 -1 -1 -1 -1 -1 - 1 -1 -1 30 -1 -1 -1 -1 -1 -1 -1 -1 32 -1 -1 -1 -1 -1 -1 -1 -1 -1 -1 -1 -1 -1 -1 -1 -1 -1 -1 10 -1 -1 10 -1 -1 -1 -1 -1 -1 -1 -1 -1 64 -1 -1 -1 - 1 -1 -1 -1 -1 -1 -1 114 -1 52 -1 -1 -1 -1 -1 -1 -1 -1 30 -1 -1 -1 -1 - 1 -1 -1 -1 32 -1 -1 -1 -1 -1 -1 -1 -1 -1 -1 -1 -1 -1 -1 -1 -1 10 -1 -1 10 -1 -1 -1 -1 -1 -1 -1 -1 64 -1 -1 -1 -1 -1 -1 -1 -1 -1 -1 -1 -1 -1 114 -1 -1 -1 52 -1 -1 -1 -1 -1 -1 -1 -1 30 -1 -1 -1 -1 -1 -1 -1 -1 -1 32 -1 -1 -1 -1 -1 -1 -1 -1 -1 -1 -1 -1 -1 -1 -1 -1 -1 -1 -1 -1 -1 -1 -1 -1 -1 -1 10 -1 -1 10 -1 -1 -1 -1 -1 -1 -1 -1 64 -1 -1 -1 -1 -1 -1 -1 -1 -1 -1 -1 -1 -1 114 -1 -1 -1 52 -1 -1 -1 -1 -1 30 -1 -1 -1 -1 -1 -1 -1 -1 32 -1 -1 -1 -1 -1 -1 -1 -1 -1 -1 -1 -1 -1 -1 -1 -1 -1 -1 10 - 1 -1 10 -1 -1 -1 -1 -1 -1 -1 64 -1 -1 -1 -1 -1 -1 -1 -1 -1 -1 -1 -1 -1 114 -1 52 -1 -1 -1 -1 -1 -1 30 -1 -1 -1 -1 -1 -1 -1 -1 32 -1 -1 -1 -1 -1 -1 -1 -1 -1 -1 -1 -1 -1 -1 -1 -1 -1 -1 -1 10 -1 -1 10 -1 -1 -1 -1 -1 -1 -1 -1 -1 45 -1 -1 -1 -1 -1 -1 70 10 -1 -1 -1 -1 -1 -1 -1 -1 -1 -1 -1 77 -1 -1 9 -1 -1 -1 -1 -1 -1 -1 -1 -1 -1 -1 -1 -1 -1 -1 -1 -1 -1 -1 -1 -1 -1 -1 -1 -1 -1 -1 -1 -1 -1 -1 10 -1 -1 10 -1 -1 -1 -1 -1 -1 -1 -1 -1 -1 45 -1 -1 -1 -1 -1 70 10 -1 -1 -1 -1 -1 -1 -1 -1 -1 -1 -1 77 -1 -1 -1 19 -1 -1- 1 -1 -1 -1 -1 -1 -1 -1 -1 -1 -1 -1 -1 -1 -1 -1 -1 -1 -1 -1 -1 -1 -1 -1 -1 -1 -1 -1 -1 -1 -1 -1 -1 10 -1 -1 10 -1 -1 -1 -1 -1 -1 45 -1 -1 -1 -1 -1 -1 70 -1 -1 -1 10 -1 -1 -1 -1 -1 -1 -1 -1 -1 -1 -1 -1 -1 -1 77 -1 19 -1 -1 -1 -1 -1 -1 -1 -1 -1 -1 -1 -1 -1 -1 -1 -1 -1 -1 -1 -1 -1 10 -1 -1 10 -1 -1 -1 -1 -1 -1 -1 45 -1 -1 -1 -1 -1 70 -1 -1 -1 10 -1 -1 -1 -1 -1 -1 -1 -1 -1 -1 -1 -1 -1 77 -1 -1 -1 19 -1 -1 -1 -1 -1 -1 -1

-1 -1 -1 -1 -1 -1 -1 -1 -1 -1 -1 -1 -1 -1 -1 -1 -1 -1 -1 -1 -1 -1 -1 -1 -1 -1 -1 -1 -1 -1 -1 -1 -1 -1 -1 -1 -1 -1 -1 10 -1 -1 10 -1 -1 -1 -1 -1 -1 12 -1 -1 56 -1 -1 -1 -1 -1 -1 -1 -1 57 35 -1 -1 -1 -1 -1 -1 -1 -1 -1 -1 -1 -1 -1 -1 - 1 -1 -1 -1 -1 -1 -1 -1 -1 -1 -1 -1 -1 -1 -1 -1 -1 -1 112 -1 -1 -1 -1 -1 -1 -1 -1 -1 -1 -1 -1 -1 -1 -1 -1 -1 -1 -1 -1 10 -1 -1 10 -1 -1 -1 12 -1 -1 -1 56 -1 -1 -1 -1 -1 -1 57 -1 -1 -1 35 -1 -1 -1 -1 -1 -1 -1 -1 -1 -1 -1 -1 -1 -1 -1 -1 -1 -1 -1 -1 -1 -1 -1 -1 -1 -1 112 -1 -1 -1

-1 -1 -1 -1 -1 57 -1 -1 35 -1 -1 -1 -1 -1 -1 -1 -1 -1 -1 -1 -1 -1 -1 -1 -1 -1 -1 -1 -1 -1 -1 -1 -1 -1 -1 -1 12 -1-1-1-1-1-1-1-1-1-1-1-1-1-1-1-1-1-1-1-1-1-1-1-1-1-1-1-1-1-1-1-1-1-1-1-1-1-1-1-1 -1 -1 -1 -1 -1 -1 -1 -1 -1 -1 -1 0 -1 -1 -1 0

-1 -1 -1 12 -1 -1 -1 56 -1 -1 -1 -1 -1 57 -1 -1 -1 35 -1 -1 -1 -1 -1 -1 -1 -1 -1 -1 -1 -1 -1 -1 -1 -1 -1 -1 -1 -1 -1 -1 -1 -1 -1 -1 112 -1 -1 -1 -1 -1 -1 -1 -1 -1 -1 -1 -1 -1 -1 -1 -1 -1 -1 -1 -1 -1 -1 -1 10 -1 -1 10 -1 -1 -1 12 -1 -1 -1 56 -1 -1 -1 57 -1 -1 -1 -1 -1 35 -1 -1 -1 -1 -1 -1 -1 -1 -1 -1 -1 -1 -1 -1 -1 -1 -1 -1 112 -1 -1 -1 -1 -1 -1 -1 -1 -1 -1 -1 -1 -1 -1 -1 -1 -1 -1 -1 -1 -1 10 -1 -1 10 -1 -1 -1 24 -1 -1 -1 -1 -1 -161 -1 -1 -1 -1 -1 60 -1 -1 -1 -1 -1 -1 -1 -1 -1 27 -151 -1 -1 -1 -1 -1 -1 -1 -1 116 -1 -1 11 -1 -1 -1 -1 -1 -1 -1 -1 -1 -1 -1 -1 -1 -1

-1 -1 -1 -1 -1 -1 -1 -1 -1 -1 -1 -1 -1 -1 -1 -1 -1 -1 -1 -1 -1 -1 -1 -1 -1 -1 10 -1 -1 -1 -1 24 -1 -1 -1 -1 -1 161 -1 -1 -1 -1 -1 60 -1 -1 -1 -1 -1 -1 -1 -1 -1 27 -151 -1 -1 -1 -1 -1 -1 -1 -1 116 -1 -1 11 -1 -1 -1 -1 -1 -1 -1 -1 -1 -1 -1 -1 -1 -1 -1 -1 -1 -1 -1 -1 -1 -1 -1 -1 -1 10 -1 -1 24 -1 -1 -1 -1 -1 -1 161 -1 -1 -1 -1 -1 160 -1 -1 -1 -1 -1 -1 -1 -1 -127 -1 -1 -1 151 -1 -1 -1 -1 -1 -1 -1 -1 116 -1 -1 11 -1 -1 -1 -1 -1 -1 -1 -1 -1 -1 -1 -1 -1 -1 -1 -1 -1 -1 -1 -1 10 -124 -1 -1 -1 -1 -1 161 -1 -1 -1 -1 -1 160 -1 -1 -1 -1

-1 -1 -1 -1 -1 -127 -1 -1 -1 -1 -151 -1 -1 -1 -1 -1 -1 -1 -1 -1 16 -1 -1 -1 1 -1 -1 -1 -1 -1-1-1-1-1-1-1-1-1-1-1-1-1-1-1-1-1-1-1-1-1-1-1-1-1-1-1-1-1-1-1-1 -1 -1 -1 -1 0]. The codebook can be defined in terms of E(H). E(H) can be mapped to H using Equations 7-9 as shown FIG. 4.

FIG. 8A, FIG. 8B and FIG. 8C are diagrams depicting an example of sequential Khatri-Rao style lifting from a base code to a new code with a longer block length, and binary matrices (referred to as "gamma matrix" or "Γ matrix") used for the lifting, according to one or more embodiments. FIG. 8A shows a sequential Khatri-Rao style lifting from a first code 802 with a block length of 1944 bits to a second code 804 with a block length of 3888 bits, and further from the second code 804 to a third code 806 with a block length of 7776 bits. In some implementations, this sequential Khatri-Rao style lifting can lead to a parity check matrix (e.g., parity check matrix 780 shown in FIG. 7C).

For example, a system according to some implementations can define (e.g., calculate, compute, obtain, generate) a base code (e.g., first code 802) as a parity check matrix H or an exponent matrix P=E(H) as in QC-LDPC code. The system can determine, based on the base code, new code matrices $\dddot{H}$ and $\dddot{P} = E(\dddot{H})$ for QC-LDPC code (e.g., third code 806) whose block length is 4 times the block length of the base code, as follows. The system can define the base code having a block length of $n_0$ (e.g., 1944 bits) using $z=z_0$ (e.g., z=81) and the exponent matrix P having a dimension of (u × v) (e.g., 24(1-R) × 24). The system can first calculate a binary matrix $\Gamma_1$ (whose dimension is 24(1-R) × 24, the same as the dimension of P). FIG. 8B shows an example of the binary matrix $\Gamma_1$ (820). The system can then determine (e.g., calculate, compute, obtain) new code matrices $\acute{H}$ and $\acute{P} = E(\acute{H})$ for QC-LDPC code (e.g., second code 804) based on the matrices H, P=E(H) (e.g., first code 802) and the binary matrix $\Gamma_1$ using Equation 15. The exponent matrix $\acute{P}$ can have a dimension of (u × v) (e.g., 24(1-R) × 24), and the new code based on matrices $\acute{H}$ and $\acute{P} = E(\acute{H})$ can have a block length of $2*n_0$ (e.g., block length of 3888 bits) using $z=2z_0$ (e.g., z=162). Next, the system can calculate another binary matrix $\Gamma_2$ (whose dimension is 24(1-R) × 24, the same as the dimension of $\acute{P}$). FIG. 8C shows an example of the binary matrix $\Gamma_2$ (840). The system can then determine (e.g., calculate, compute, obtain) new code matrices $\dddot{H}$ and $\dddot{P} = E(\dddot{H})$ for QC-LDPC code (e.g., third code 806) based on the matrices $\acute{H}, \acute{P} = E(\acute{H})$ (e.g., second code 804) and the binary matrix $\Gamma_2$ using Equation 15. The exponent matrix $\dddot{P}$ (e.g., third code 806) can have a dimension of (24(1-R) × 24), and the new code based on matrices $\dddot{H}$ and $\dddot{P} = E(\dddot{H})$ can have a block length of $4*n_0$ (e.g., block length of 7776 bits) using $z=4z_0$ (e.g., z=324).

FIG. 9A and FIG. 9B are diagrams depicting an example of Khatri-Rao style lifting from a base code to a new code with a longer block length, and a binary matrix (referred to as "lambda matrix" or "λ matrix") used for the lifting, according to one or more embodiments. FIG. 9A shows a direct block-Kronecker/Khatri-Rao style lifting from a base code 902 with a block length of 1944 bits to a new code 904 with a block length of 7776 bits. In some implementations, this Khatri-Rao style lifting can lead to a parity check matrix (e.g., parity check matrix 750 shown in FIG. 7B).

For example, a system according to some implementations can define (e.g., calculate, compute, obtain, generate) a base code (e.g., base code 902) as a parity check matrix H or an exponent matrix P=E(H) as in QC-LDPC code, and determine new code matrices $\ddot{H}$ and $\ddot{P} = E(\ddot{H})$ for QC-LDPC code (e.g., new code 904) whose block length is 4 times the block length of the base code. The system can calculate (e.g., generate, compute, obtain, determine) a binary matrix $\lambda$, which has 4 times the size of P=E(H). FIG. 9B shows an example of the binary matrix $\lambda$ (950). For example, if E(H) has a dimension of (u × v) (e.g., 24(1-R) × 24), $\lambda$ has a dimension of (4u × 4v) (e.g., 96(1-R) × 96). The matrix $\lambda$ (e.g., matrix $\lambda$ 950) can internally include sub-matrices which are powers of exchange matrix J(2) and/or one or more zero matrices. The system can determine (e.g., calculate, compute, obtain) new code matrices $\ddot{H}$ and $\ddot{P} = E(\ddot{H})$ using Equation 16. $\ddot{P} = E(\ddot{H})$ can have the same size as that of $\lambda$, and has a dimension of (4u × 4v). If P=E(H) has a dimension of (24 × 24(1 - R)), $\lambda$ will have a dimension of (96(1-R) × 96). For example, the system can determine new code matrices $\ddot{H}$ and $\ddot{P} = E(\ddot{H})$ for QC-LDPC code 904 (n=7776, k=3888, R=1/2) from the base code 902 (n=1944, k=1620, R=1/2) using Equation 16.

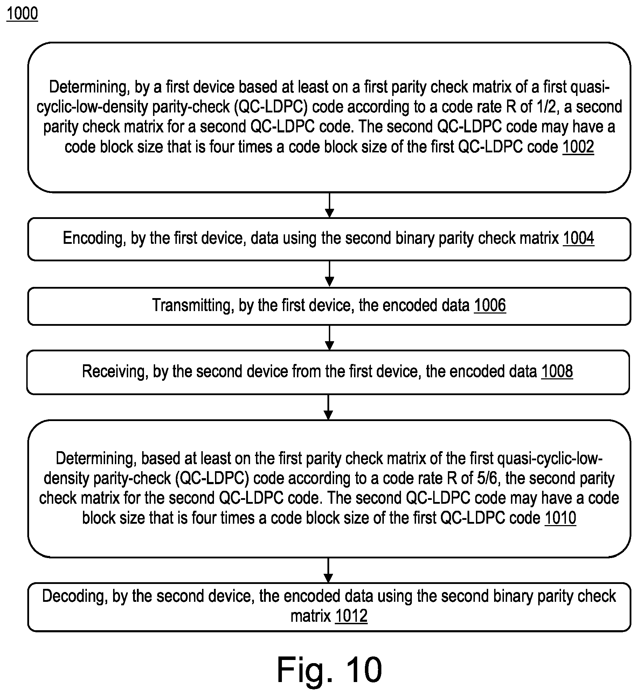

FIG. 10 is a flow diagram showing a process 1100 for encoding data and/or decoding data using an LDPC code, in accordance with an embodiment. In some embodiments, the process 1000 is performed by one or more processors of a first device (e.g. encoder 130 or processor 2010 of communication system 105) or by one or more processors of a second device (e.g. decoder 160 or processor 2010 of communication system 108). In other embodiments, the process 1000 is performed by other entities (e.g., a computing system other than the communication system 105 or 108). In some embodiments, the process 1000 includes more, fewer, or different steps than shown in FIG. 10.

At step 1002, the first device (e.g., communication system 105) may determine, based at least on a first parity check matrix of a first quasi-cyclic-low-density parity-check (QC-LDPC) code (e.g., QC-LDPC code 802, 902) according to a code rate R of 1/2, a second parity check matrix for a second QC-LDPC code (e.g., QC-LDPC code 806, 904). The second QC-LDPC code may have a code block size (e.g., 7776 bits) that is four times a code block size (e.g., 1944 bits) of the first QC-LDPC code. In some implementations, the code block size of the second QC-LDPC code may be 7776 bits.

In some implementations, the first device may identify the first parity check matrix of the first QC-LDPC code (e.g., QC-LDPC code 802, 902) having the code rate of 1/2. The first device may determine a first binary matrix (e.g., gamma matrix $\Gamma_1$ or lambda matrix $\lambda$), and determine, based at least on the first parity check matrix and the first binary matrix, a first Khatri-Rao product (e.g., Equation 15 or Equation 16). The first device may determine, using the first Khatri-Rao product, the second parity check matrix (e.g., parity check matrix 750, or parity check matrix for QC-LDPC code 806, 904).

In some implementations, in determining the second parity check matrix, the first device may determine, using the first Khatri-Rao product, a third parity check matrix (e.g., parity check matrix for the second code 804), and determine a second binary matrix (e.g., gamma matrix $\Gamma_2$) having the same size (e.g., 24(1-R) $\times$ 24) as a size of the first binary matrix (e.g., gamma matrix $\Gamma_1$). The first device may determine, based at least on the third parity check matrix and the second binary matrix, a second Khatri-Rao product (e.g., Equation 15). The first device may determine, using the second Khatri-Rao product, the second parity check matrix.

In some implementations, the first binary matrix (e.g., gamma matrix $\Gamma_1$) may include the following set of values: [1 1 1 1 1 1 0 1 0 1 1 0 0 1 1 1 1 1 1 1 1 1 1 1 1 1 1 1 1 0 1 1 1 1 0 0 1 1 1 1 1 1 1 0 1 1 1 0 1 1 0 1 1 1 1 0 0 1 1 1 1 1 1 1 0 0 1 1 1 1 1 0 0 1 1 1 1 1 1 0 0 1 1 1 1 1 1 1 1 1 0 0 1 1 1 1 1 1 1 1 1 1 1 1 0 0 1 1 1 1 1 1 0 1 1 1 0 1 0 1 1 1 1 0 1 1 1 1 0 0 1 1 1 1 0 0 0 1 1 1 1 1 0 1 1 0 1 1 1 1 0 0 1 1 1 1 0 1 1 1 0 0 1 1 0 1 1 1 1 1 1 1 1 1 0 0 1 1 1 1 1 1 1 0 0 1 1 1 1 1 1 1 1 1 1 1 1 1 0 0 1 1 1 1 1 0 1 1 1 0 0 1 1 1 1 1 1 1 1 1 1 1 0 0 1 0 0 1 1 0 1 1 1 1 1 0 1 1 1 1 1 1 1 1 1 0 0 1 1 1 1 1 1 1 0 1 1 0 0 1 1 1 1 1 1 1 1 1 1 0].

The second binary matrix (e.g., gamma matrix $\Gamma_2$) may include the following set of values: [1 1 1 1 1 1 1 1 0 1 0 1 0 0 1 1 1 1 1 1 1 1 1 0 1 1 0 1 1 0 1 1 1 1 0 0 1 1 1 1 1 1 1 1 1 0 1 1 1 0 1 1 0 1 1 1 1 0 0 1 1 1 1 1 1 1 1 0 0 1 1 1 1 1 0 0 1 1 1 1 1 0 0 1 1 1 1 1 1 1 1 1 1 0 1 1 1 1 1 1 1 1 1 1 0 0 1 1 1 1 1 0 1 1 1 1 0 1 1 1 1 1 1 1 1 1 1 1 0 0 1 1 1 1 1 0 1 1 1 0 1 1 1 1 0 1 1 1 1 0 0 1 1 1 1 1 1 1 0 1 1 1 1 1 1 1 1 1 1 1 0 0 1 1 1 1 1 1 0 1 1 1 1 1 1 1 1 1 1 1 1 0 0 1 1 0 1 1 1 1 1 1 0 1 1 1 1 1 1 1 1 1 1 0 0 1 0 0 1 1 0 1 1 1 1 1 1 1 1 1 1 1 1 1 1 1 0 0 1 1 1 1 1 1 1 0 0 1 1 0 0 1 1 1 1 1 1 1 1 1 1 0].

In some implementations, the first binary matrix (e.g., lambda matrix $\lambda$) may have a dimension that (1) is different from a dimension of an exponent matrix corresponding to the first parity check matrix (e.g., 24(1-R) $\times$ 24) and (2) is the same as a dimension of an exponent matrix corresponding to the second parity check matrix (e.g., 96(1-R) $\times$ 96). In some implementations, an exponent matrix corresponding to the first parity check matrix may have a dimension of (24(1-R) $\times$ 24). An exponent matrix corresponding to the second parity check matrix may have a dimension of (96(1-R) $\times$ 96). The first binary matrix may have a dimension of (96(1-R) $\times$ 96).

At step 1004, the first device may encode data using the second parity check matrix. At step 1006, the first device (e.g., transmitter circuitry 120) may transmit the encoded data.

At step 1008, the second device may receive, from the first device (e.g., communication system 105), the encoded data. At step 1010, the second device (e.g., decoder 160 or processor 2010 of communication system 108) may determine, based at least on the first parity check matrix of the first QC-LDPC code (e.g., QC-LDPC code 802, 902) according to a code rate R of 1/2, the second parity check matrix for the second QC-LDPC code (e.g., parity check matrix 750, or parity check matrix for QC-LDPC code 806, 904). The second QC-LDPC code may have a code block size (e.g., 7776 bits) that is four times a code block size (e.g., 1944 bits) of the first QC-LDPC code. In some implementations, the code block size of the second QC-LDPC code may be 7776 bits.

At step 1012, the second device may decode the received encoded data using the second binary parity check matrix.

In some implementations, an exponent matrix corresponding to the second parity check matrix may have a dimension of (96(1-R) $\times$ 96). In some implementations, the second device may identify the first parity check matrix of the first QC-LDPC code having the code rate of 1/2. In some implementations, the second device may determine a first binary matrix (e.g., gamma matrix $\Gamma_1$ or lambda matrix $\lambda$), and determine, based at least on the first parity check matrix and the first binary matrix, a first Khatri-Rao product (e.g., using Equation 15 or Equation 16). The second device may determine, using the first Khatri-Rao product, the second parity check matrix.

References to "or" may be construed as inclusive so that any terms described using "or" may indicate any of a single, more than one, and all of the described terms. References to at least one of a conjunctive list of terms may be construed as an inclusive OR to indicate any of a single, more than one, and all of the described terms. For example, a reference to "at least one of 'A' and 'B'" can include only 'A', only 'B', as well as both 'A' and 'B'. Such references used in conjunction with "comprising" or other open terminology can include additional items.

It should be noted that certain passages of this disclosure can reference terms such as "first" and "second" in connection with subsets of transmit spatial streams, sounding frames, response, and devices, for purposes of identifying or differentiating one from another or from others. These terms are not intended to merely relate entities (e.g., a first device and a second device) temporally or according to a sequence, although in some cases, these entities can include such a relationship. Nor do these terms limit the number of possible entities (e.g., STAs, APs, beamformers and/or beamformees) that can operate within a system or environment. It should be understood that the systems described above can provide multiple ones of any or each of those components and these components can be provided on either a standalone machine or, in some embodiments, on multiple machines in a distributed system. Further still, bit field positions can be changed and multibit words can be used. In addition, the systems and methods described above can be provided as one or more computer-readable programs or executable instructions embodied on or in one or more articles of manufacture, e.g., a floppy disk, a hard disk, a CD-ROM, a flash memory card, a PROM, a RAM, a ROM, or a magnetic tape. The programs can be implemented in any programming language, such as LISP, PERL, C, C++, C#, or in any byte code language such as JAVA. The software programs or executable instructions can be stored on or in one or more articles of manufacture as object code.

While the foregoing written description of the methods and systems enables one of ordinary skill to make and use embodiments thereof, those of ordinary skill will understand and appreciate the existence of variations, combinations, and equivalents of the specific embodiment, method, and examples herein. The present methods and systems should therefore not be limited by the above described embodiments, methods, and examples, but by all embodiments and methods within the scope and spirit of the disclosure.

**Claims**

1. An apparatus (105) comprising:

    a transmitter (120) and one or more processors, wherein
    the one or more processors (2010) are configured to:

        determine, based at least on a first parity check matrix of a first quasi-cyclic-low-density parity-check, QC-LDPC, code according to a code rate R of 1/2, a second parity check matrix for a second QC-LDPC code, wherein the second QC-LDPC code has a code block size that is four times a code block size of the first QC-LDPC code; and
        encode data using the second parity check matrix, and

    the transmitter (120) is configured to transmit the encoded data.

2. The apparatus (105) of claim 1, wherein the code block size of the second QC-LDPC code is 7776 bits.

3. The apparatus (105) of claim 1 or 2, wherein the one or more processors (2010) are further configured to:

    identify the first parity check matrix of the first QC-LDPC code having the code rate of 1/2;
    determine a first binary matrix;
    determine, based at least on the first parity check matrix and the first binary matrix, a first Khatri-Rao product; and
    determine, using the first Khatri-Rao product, the second parity check matrix.

4. The apparatus (105) of claim 3, wherein in determining the second parity check matrix, the one or more processors (2010) are configured to:

    determine, using the first Khatri-Rao product, a third parity check matrix;
    determine a second binary matrix having the same size as a size of the first binary matrix;
    determine, based at least on the third parity check matrix and the second binary matrix, a second Khatri-Rao product; and
    determine, using the second Khatri-Rao product, the second parity check matrix.

5. The apparatus (105) of claim 4, comprising at least one of the following features:

    wherein
    the first binary matrix comprises the following set of values: [1 1 1 1 1 1 0 1 0 1 1 0 0 1 1 1 1 1 1 1 1 1 1 1 1 1 1 1 0 1 1 1 1 0 0 1 1 1 1 1 1 1 1 0 1 1 1 1 0 1 1 0 1 1 1 1 0 0 1 1 1 1 1 1 1 0 0 1 1 1 1 1 0 0 1 1 1 1 1 0 0 1 1 1 1 1 1 1 1 1 0 0 1 1 1 1 1 1 1 1 1 1 1 0 0 1 1 1 1 1 1 0 1 1 1 0 1 0 1 1 1 0 1 1 1 1 0 0 1 1 1 1 0 0 0 1 1 1 1 0 1 1 1 0 1 1 1 1 1 0 0 1 1 1 1 0 1 1 1 0 0 1 1 0 1 0 1 1 1 1 1 1 1 0 0 1 1 1 1 1 1 1 0 0 1 1 1 1 1 1 1 1 1 1 1 1 0 0 1 1 1 1 1 1 0 1 1 1 0 0 1 1 1 1 1 1 1 1 1 1 0 0 1 0 0 1 1 0 1 1 1 1 1 0 1 1 1 1 1 1 1 1 1 1 0 0 1 1 1 1 1 1 1 0 1 1 0 0 1 1 1 1 1 1 1 1 1 1 1 0];
    wherein
    the second binary matrix comprises the following set of values: [1 1 1 1 1 1 1 1 0 1 0 1001111111111011101110111 0111100111111110111101101111 1001111111100111110011111100111111111101111111111 1001111111101111 101111111111001111110111101111101111 1 0 0 1 1 1 1 1 1 1 1 1 0 1 1 1 1 1 1 1 1 1 1 1 1 1 0 0 1 1 1 1 1 1 0 1 1 1111111111111100111101111111011111111111100100110111111111111111111100111111100 1 1 0 0 1 1 1 1 1 1 1 1 1 1 0].

6. The apparatus (105) of any of claims 3 to 5, comprising at least one of the following features:

    wherein
    the first binary matrix has a dimension that (1) is different from a dimension of an exponent matrix corresponding to the first parity check matrix and (2) is the same as a dimension of an exponent matrix corresponding to the second parity check matrix;
wherein

an exponent matrix corresponding to the first parity check matrix has a dimension of (24(1-R) × 24),
an exponent matrix corresponding to the second parity check matrix has a dimension of (96(1-R) × 96), and
the first binary matrix has a dimension of (96(1-R) × 96).

7. A method, comprising:

determining, by one or more processors (2010) of a first device (105) based at least on a first parity check matrix of a first quasi-cyclic-low-density parity-check, QC-LDPC, code according to a code rate R of 1/2, a second parity check matrix for a second QC-LDPC code, wherein the second QC-LDPC code has a code block size that is four times a code block size of the first QC-LDPC code;
encoding, by the one or more processors (2010) of the first device (105), data using the second parity check matrix; and
transmitting, by a transmitter (120) of the first device (105), the encoded data.

8. The method of claim 7, wherein the code block size of the second QC-LDPC code is 7776 bits.

9. The method of any of claims 7 or 8, further comprising:

identifying the first parity check matrix of the first QC-LDPC code having the code rate of 1/2;
determining a first binary matrix;
determining, based at least on the first parity check matrix and the first binary matrix, a first Khatri-Rao product; and
determining, using the first Khatri-Rao product, the second parity check matrix.

10. The method of claim 9, wherein determining the second parity check matrix comprises:

determining, using the first Khatri-Rao product, a third parity check matrix;
determining a second binary matrix having the same size as a size of the first binary matrix;
determining, based at least on the third parity check matrix and the second binary matrix, a second Khatri-Rao product; and
determining, using the second Khatri-Rao product, the second parity check matrix.

11. The method of claim 10, comprising at least one of the following features:

wherein
the first binary matrix comprises the following set of values: [1 1 1 1 1 1 0 1 0 1 1 1 0 0 1 1 1 1 1 1 1 1 1 1 1 1 1 1 1 0 1 1 1 1 0 0 1 1 1 1 1 1 1 1 0 1 1 1 1 0 1 1 0 1 1 1 1 1 0 0 1 1 1 1 1 1 1 1 0 0 1 1 1 1 1 0 0 1 1 1 1 1 1 0 0 1 1 1 1 1 1 1 1 1 0 0 1 1 1 1 1 1 1 1 1 1 0 0 1 1 1 1 1 1 1 1 1 1 0 0 1 1 1 1 1 1 1 0 1 1 1 0 1 0 1 1 1 0 1 1 1 1 0 0 1 1 1 1 0 0 0 1 1 1 1 0 1 1 1 0 1 1 1 1 1 0 0 1 1 1 1 1 1 1 1 0 0 1 1 1 1 1 1 1 0 0 1 1 1 1 1 1 1 1 1 1 1 0 0 1 1 1 1 1 1 0 1 1 1 0 0 1 1 1 1 1 1 1 1 1 1 0 0 1 0 0 1 1 0 1 1 1 1 1 0 1 1 1 1 1 1 1 1 1 1 0 0 1 1 1 1 1 1 1 0 1 1 0 0 1 1 1 1 1 1 1 1 1 1 0];
wherein
the second binary matrix comprises the following set of values: [1 1 1 1 1 1 1 1 0 1 0 1 0 0 1 1 1 1 1 1 1 1 1 1 0 1 1 1 0 1 1 1 0 1 1 1 1 0 0 1 1 1 1 1 1 1 1 0 1 1 1 0 1 1 0 1 1 1 1 1 0 0 1 1 1 1 1 1 1 1 0 0 1 1 1 1 1 0 0 1 1 1 1 1 1 0 0 1 1 1 1 1 1 1 1 1 1 0 1 1 1 1 1 1 1 1 1 1 0 0 1 1 1 1 1 1 0 1 1 1 1 1 0 0 1 1 1 1 1 0 1 1 1 0 1 1 1 1 0 1 1 1 1 0 1 1 1 1 0 0 1 1 1 1 1 1 1 1 0 1 1 1 1 1 1 1 1 1 1 1 0 0 1 1 1 1 1 1 0 1 1 1 1 1 1 1 1 1 1 1 1 1 1 1 0 0 1 1 1 0 1 1 1 1 1 1 1 1 0 1 1 1 1 1 1 1 1 1 1 1 1 0 0 1 0 0 1 1 0 1 1 1 1 1 1 1 1 1 1 1 1 1 1 1 1 1 0 0 1 1 1 1 1 1 1 0 0 1 1 0 0 1 1 1 1 1 1 1 1 1 1 0].

12. The method of any of claims 9 to 11, comprising at least one of the following features:

wherein
the first binary matrix has a dimension that (1) is different from a dimension of an exponent matrix corresponding to the first parity check matrix and (2) is the same as a dimension of an exponent matrix corresponding to the second parity check matrix;
wherein

an exponent matrix corresponding to the first parity check matrix has a dimension of (24(1-R) × 24),
an exponent matrix corresponding to the second parity check matrix has a dimension of (96(1-R) × 96), and
the first binary matrix has a dimension of (96(1-R) × 96).

13. An apparatus (108) comprising:

A receiver (140) configured to receive encoded data; and
one or more processors (2010) configured to:

determine, based at least on a first parity check matrix of a first quasi-cyclic-low-density parity-check, QC-LDPC, code according to a code rate R of 1/2, a second parity check matrix for a second QC-LDPC code, wherein the second QC-LDPC code has a code block size that is four times a code block size of the first QC-LDPC code; and
decode the received encoded data using the second binary parity check matrix.

14. The apparatus (108) of claim 13, comprising at least one of the following features:

wherein the code block size of the second QC-LDPC code is 7776 bits;
wherein an exponent matrix corresponding to the second parity check matrix has a dimension of (96(1-R) × 96).

15. The apparatus (108) of any of claims 1 to 6, wherein the one or more processors (2010) are further configured to:

identify the first parity check matrix of the first QC-LDPC code having the code rate of 1/2;
determine a first binary matrix;
determine, based at least on the first parity check matrix and the first binary matrix, a first Khatri-Rao product; and
determine, using the first Khatri-Rao product, the second parity check matrix.

Fig. 1

EP 4 675 950 A1

Computing system 2000

Cache
2020

Processor
2010

I/O Components
2050

Display
2070

Input Device
2080

Communication System 2040

Memory
2060

Network Interface
Device 2030

Fig. 2

300

24R     1     24(1-R)-1

312

24(1-R)-1

A
310

B

T
314

24(1-R)

1

C   316

D

E 320

318

# Fig. 3

400

7x7 SparseMatrixCSC{Int64, Int64} with 0 stored entries:

d=-1
409

7x7 SparseMatrixCSC{Bool, Int64} with 7 stored entries:

d=0
410

7x7 SparseMatrixCSC(Bool, Int64) with 7 stored entries:

d=1
411

7x7 SparseNatrixCSC(Bool, Int64) with 7 stored entries:

d=2
412

7x7 SparseMatrixCSC(Bool, Int64) with 7 stored entries:

d=3
413

7x7 SparseMatrixCSC(Bool, Int64] with 7 stored entries:

d=4
414

7x7 SparseNatrixCSC(Bool, Int64) with 7 stored entries:

d=5
415

7x7 SparseMatrixCSC(Bool, Int64) with 7 stored entries:

d=6
416

Fig. 4

EP 4 675 950 A1

500

Fig. 5

600

Fig. 6

700  Exponent Matrix $P = E(H)$

| | 1 | 2 | 3 | 4 | 5 | 6 | 7 | 8 | 9 | 10 | 11 | 12 | 13 | 14 | 15 | 16 | 17 | 18 | 19 | 20 | 21 | 22 | 23 | 24 | 25 | 26 | 27 | 28 | 29 | 30 | 31 | 32 |
|---|---|---|---|---|---|---|---|---|---|---|---|---|---|---|---|---|---|---|---|---|---|---|---|---|---|---|---|---|---|---|---|---|
| 1 | -1 | -1 | -1 | 57 | -1 | -1 | -1 | -1 | -1 | -1 | -1 | -1 | -1 | -1 | -1 | -1 | -1 | -1 | -1 | 50 | -1 | -1 | -1 | -1 | -1 | 11 | -1 | -1 | -1 | -1 | -1 | -1 |
| 2 | -1 | -1 | 57 | -1 | -1 | -1 | -1 | -1 | -1 | -1 | -1 | -1 | -1 | -1 | -1 | -1 | -1 | -1 | -1 | 50 | -1 | -1 | -1 | -1 | -1 | 11 | -1 | -1 | -1 | -1 | -1 | -1 |
| 3 | -1 | 57 | -1 | -1 | -1 | -1 | -1 | -1 | -1 | -1 | -1 | -1 | -1 | -1 | -1 | -1 | -1 | -1 | -1 | 50 | -1 | -1 | -1 | -1 | -1 | 11 | -1 | -1 | -1 | -1 | -1 | -1 |
| 4 | 57 | -1 | -1 | -1 | -1 | -1 | -1 | -1 | -1 | -1 | -1 | -1 | -1 | -1 | -1 | -1 | -1 | -1 | -1 | 50 | -1 | -1 | -1 | -1 | -1 | 11 | -1 | -1 | -1 | -1 | -1 | -1 |
| 5 | -1 | -1 | 3 | -1 | -1 | -1 | -1 | -1 | -1 | -1 | -1 | 28 | -1 | -1 | -1 | -1 | -1 | -1 | -1 | 0 | -1 | -1 | -1 | -1 | -1 | -1 | -1 | -1 | -1 | -1 | -1 | -1 |
| 6 | -1 | -1 | -1 | 3 | -1 | -1 | -1 | -1 | -1 | -1 | 28 | -1 | -1 | -1 | -1 | -1 | -1 | -1 | -1 | 0 | -1 | -1 | -1 | -1 | -1 | -1 | -1 | -1 | -1 | -1 | -1 | -1 |
| 7 | 3 | -1 | -1 | -1 | -1 | -1 | -1 | -1 | -1 | 28 | -1 | -1 | -1 | -1 | -1 | -1 | -1 | -1 | -1 | 0 | -1 | -1 | -1 | -1 | -1 | -1 | -1 | -1 | -1 | -1 | -1 | -1 |
| 8 | -1 | 3 | -1 | -1 | -1 | -1 | -1 | -1 | 28 | -1 | -1 | -1 | -1 | -1 | -1 | -1 | -1 | -1 | -1 | 0 | -1 | -1 | -1 | -1 | -1 | -1 | -1 | -1 | -1 | -1 | N | -1 |
| 9 | 30 | -1 | -1 | -1 | -1 | -1 | -1 | -1 | -1 | -1 | -1 | -1 | -1 | -1 | -1 | -1 | -1 | -1 | -1 | 24 | 37 | -1 | -1 | -1 | -1 | -1 | -1 | -1 | -1 | -1 | -1 | -1 |
| 10 | -1 | 30 | -1 | -1 | -1 | -1 | -1 | -1 | -1 | -1 | -1 | -1 | -1 | -1 | -1 | -1 | -1 | -1 | -1 | 24 | -1 | 37 | -1 | -1 | -1 | -1 | -1 | -1 | -1 | -1 | -1 | -1 |
| 11 | -1 | -1 | 30 | -1 | -1 | -1 | -1 | -1 | -1 | -1 | -1 | -1 | -1 | -1 | -1 | -1 | -1 | -1 | -1 | 24 | -1 | -1 | 37 | -1 | -1 | -1 | -1 | -1 | -1 | -1 | -1 | -1 |
| 12 | -1 | -1 | -1 | 30 | -1 | -1 | -1 | -1 | -1 | -1 | -1 | -1 | -1 | -1 | -1 | -1 | -1 | -1 | -1 | 24 | -1 | -1 | -1 | 37 | -1 | -1 | -1 | -1 | -1 | -1 | -1 | -1 |
| 13 | 62 | -1 | -1 | -1 | 53 | -1 | -1 | -1 | -1 | -1 | -1 | -1 | -1 | -1 | -1 | -1 | -1 | -1 | -1 | 53 | -1 | -1 | -1 | -1 | -1 | -1 | -1 | -1 | 3 | -1 | -1 | -1 |
| 14 | -1 | 62 | -1 | -1 | -1 | 53 | -1 | -1 | -1 | -1 | -1 | -1 | -1 | -1 | -1 | -1 | -1 | -1 | -1 | 53 | -1 | -1 | -1 | -1 | -1 | -1 | -1 | -1 | -1 | 3 | -1 | -1 |
| 15 | -1 | -1 | 62 | -1 | -1 | -1 | 53 | -1 | -1 | -1 | -1 | -1 | -1 | -1 | -1 | -1 | -1 | -1 | -1 | 53 | -1 | -1 | -1 | -1 | -1 | -1 | -1 | -1 | -1 | -1 | 3 | -1 |
| 16 | -1 | -1 | -1 | 62 | -1 | -1 | -1 | 53 | -1 | -1 | -1 | -1 | -1 | -1 | -1 | -1 | -1 | -1 | -1 | 53 | -1 | -1 | -1 | -1 | -1 | -1 | -1 | -1 | -1 | -1 | -1 | 3 |
| 17 | -1 | -1 | -1 | 40 | -1 | -1 | -1 | -1 | -1 | -1 | -1 | -1 | 20 | -1 | -1 | -1 | -1 | -1 | -1 | 66 | -1 | -1 | -1 | -1 | -1 | -1 | -1 | -1 | -1 | -1 | -1 | 22 |
| 18 | -1 | -1 | 40 | -1 | -1 | -1 | -1 | -1 | -1 | -1 | -1 | -1 | -1 | 20 | -1 | -1 | -1 | -1 | -1 | 66 | -1 | -1 | -1 | -1 | -1 | -1 | -1 | -1 | -1 | -1 | 22 | -1 |
| 19 | -1 | 40 | -1 | -1 | -1 | -1 | -1 | -1 | -1 | -1 | -1 | -1 | -1 | -1 | 20 | -1 | -1 | -1 | -1 | 66 | -1 | -1 | -1 | -1 | -1 | -1 | -1 | -1 | -1 | 22 | -1 | -1 |
| 20 | 40 | -1 | -1 | -1 | -1 | -1 | -1 | -1 | -1 | -1 | -1 | -1 | -1 | -1 | -1 | 20 | -1 | -1 | -1 | 66 | -1 | -1 | -1 | -1 | -1 | -1 | -1 | -1 | 22 | -1 | -1 | -1 |
| 21 | 0 | -1 | -1 | -1 | -1 | -1 | -1 | -1 | -1 | -1 | -1 | -1 | -1 | -1 | -1 | -1 | -1 | -1 | -1 | 8 | -1 | -1 | -1 | -1 | -1 | 42 | -1 | -1 | -1 | -1 | -1 | -1 |
| 22 | -1 | 0 | -1 | -1 | -1 | -1 | -1 | -1 | -1 | -1 | -1 | -1 | -1 | -1 | -1 | -1 | -1 | -1 | -1 | 8 | -1 | -1 | -1 | -1 | -1 | 42 | -1 | -1 | -1 | -1 | -1 | -1 |
| 23 | -1 | -1 | 0 | -1 | -1 | -1 | -1 | -1 | -1 | -1 | -1 | -1 | -1 | -1 | -1 | -1 | -1 | -1 | -1 | 8 | -1 | -1 | -1 | -1 | -1 | 42 | -1 | -1 | -1 | -1 | -1 | -1 |
| 24 | -1 | -1 | -1 | 0 | -1 | -1 | -1 | -1 | -1 | -1 | -1 | -1 | -1 | -1 | -1 | -1 | -1 | -1 | -1 | 8 | -1 | -1 | -1 | -1 | -1 | 42 | -1 | -1 | -1 | -1 | -1 | -1 |
| 25 | -1 | 69 | -1 | -1 | 79 | -1 | -1 | -1 | 79 | -1 | -1 | -1 | -1 | -1 | -1 | -1 | -1 | -1 | -1 | -1 | -1 | -1 | -1 | -1 | -1 | 56 | -1 | -1 | -1 | -1 | -1 | -1 |
| 26 | 69 | -1 | -1 | -1 | -1 | 79 | -1 | -1 | -1 | 79 | -1 | -1 | -1 | -1 | -1 | -1 | -1 | -1 | -1 | -1 | -1 | -1 | -1 | -1 | -1 | 56 | -1 | -1 | -1 | -1 | -1 | -1 |
| 27 | -1 | -1 | -1 | 69 | -1 | -1 | 79 | -1 | -1 | -1 | 79 | -1 | -1 | -1 | -1 | -1 | -1 | -1 | -1 | -1 | -1 | -1 | -1 | -1 | -1 | 56 | -1 | -1 | -1 | -1 | -1 | -1 |
| 28 | -1 | -1 | 69 | -1 | -1 | -1 | -1 | 79 | -1 | -1 | -1 | 79 | -1 | -1 | -1 | -1 | -1 | -1 | -1 | -1 | -1 | -1 | -1 | -1 | -1 | 56 | -1 | -1 | -1 | -1 | -1 | -1 |
| 29 | -1 | 65 | -1 | -1 | -1 | -1 | -1 | -1 | -1 | -1 | -1 | -1 | -1 | -1 | -1 | -1 | -1 | -1 | -1 | 38 | -1 | -1 | -1 | 57 | -1 | -1 | -1 | -1 | -1 | -1 | -1 | -1 |
| 30 | 65 | -1 | -1 | -1 | -1 | -1 | -1 | -1 | -1 | -1 | -1 | -1 | -1 | -1 | -1 | -1 | -1 | -1 | -1 | 38 | -1 | -1 | 57 | -1 | -1 | -1 | -1 | -1 | -1 | -1 | -1 | -1 |
| 31 | -1 | -1 | -1 | 65 | -1 | -1 | -1 | -1 | -1 | -1 | -1 | -1 | -1 | -1 | -1 | -1 | -1 | -1 | -1 | 38 | -1 | 57 | -1 | -1 | -1 | -1 | -1 | -1 | -1 | -1 | -1 | -1 |
| 32 | -1 | -1 | 65 | -1 | -1 | -1 | -1 | -1 | -1 | -1 | -1 | -1 | -1 | -1 | -1 | -1 | -1 | -1 | -1 | 38 | 57 | -1 | -1 | -1 | -1 | -1 | -1 | -1 | -1 | -1 | -1 | -1 |
| 33 | -1 | -1 | -1 | 64 | -1 | -1 | -1 | -1 | -1 | -1 | -1 | -1 | -1 | -1 | -1 | -1 | -1 | -1 | -1 | 14 | -1 | -1 | -1 | 52 | -1 | -1 | -1 | -1 | -1 | -1 | -1 | -1 |
| 34 | -1 | -1 | 64 | -1 | -1 | -1 | -1 | -1 | -1 | -1 | -1 | -1 | -1 | -1 | -1 | -1 | -1 | -1 | -1 | 14 | -1 | -1 | 52 | -1 | -1 | -1 | -1 | -1 | -1 | -1 | -1 | -1 |
| 35 | -1 | 64 | -1 | -1 | -1 | -1 | -1 | -1 | -1 | -1 | -1 | -1 | -1 | -1 | -1 | -1 | -1 | -1 | -1 | 14 | -1 | 52 | -1 | -1 | -1 | -1 | -1 | -1 | -1 | -1 | -1 | -1 |
| 36 | 64 | -1 | -1 | -1 | -1 | -1 | -1 | -1 | -1 | -1 | -1 | -1 | -1 | -1 | -1 | -1 | -1 | -1 | -1 | 14 | 52 | -1 | -1 | -1 | -1 | -1 | -1 | -1 | -1 | -1 | -1 | -1 |
| 37 | -1 | -1 | -1 | -1 | -1 | 45 | -1 | -1 | -1 | -1 | -1 | -1 | -1 | -1 | -1 | -1 | 70 | -1 | 0 | -1 | -1 | -1 | -1 | -1 | -1 | -1 | -1 | -1 | -1 | -1 | -1 | -1 |
| 38 | -1 | -1 | -1 | -1 | -1 | -1 | 45 | -1 | -1 | -1 | -1 | -1 | -1 | -1 | -1 | -1 | 70 | -1 | 0 | -1 | -1 | -1 | -1 | -1 | -1 | -1 | -1 | -1 | -1 | -1 | -1 | -1 |
| 39 | -1 | -1 | -1 | -1 | 45 | -1 | -1 | -1 | -1 | -1 | -1 | -1 | -1 | -1 | -1 | -1 | 70 | -1 | 0 | -1 | -1 | -1 | -1 | -1 | -1 | -1 | -1 | -1 | -1 | -1 | -1 | -1 |
| 40 | -1 | -1 | -1 | -1 | -1 | 45 | -1 | -1 | -1 | -1 | -1 | -1 | -1 | -1 | -1 | -1 | 70 | -1 | 0 | -1 | -1 | -1 | -1 | -1 | -1 | -1 | -1 | -1 | -1 | -1 | -1 | -1 |
| 41 | 2 | -1 | -1 | -1 | 56 | -1 | -1 | -1 | -1 | -1 | -1 | -1 | -1 | -1 | -1 | -1 | 57 | 35 | -1 | -1 | -1 | -1 | -1 | -1 | -1 | -1 | -1 | -1 | -1 | -1 | -1 | -1 |
| 42 | -1 | 2 | -1 | -1 | -1 | 56 | -1 | -1 | -1 | -1 | -1 | -1 | -1 | -1 | -1 | -1 | 57 | -1 | -1 | 35 | -1 | -1 | -1 | -1 | -1 | -1 | -1 | -1 | -1 | -1 | -1 | -1 |
| 43 | -1 | -1 | 2 | -1 | -1 | -1 | 56 | -1 | -1 | -1 | -1 | -1 | -1 | -1 | -1 | -1 | 57 | -1 | 35 | -1 | -1 | -1 | -1 | -1 | -1 | -1 | -1 | -1 | -1 | -1 | -1 | -1 |
| 44 | -1 | -1 | -1 | 2 | -1 | -1 | -1 | 56 | -1 | -1 | -1 | -1 | -1 | -1 | -1 | -1 | 57 | -1 | 35 | -1 | -1 | -1 | -1 | -1 | -1 | -1 | -1 | -1 | -1 | -1 | -1 | -1 |
| 45 | -1 | -1 | -1 | 24 | -1 | -1 | -1 | -1 | -1 | -1 | -1 | 61 | -1 | -1 | -1 | -1 | 60 | -1 | -1 | -1 | -1 | -1 | -1 | -1 | -1 | -1 | -1 | -1 | -1 | -1 | 27 | -1 |
| 46 | -1 | -1 | 24 | -1 | -1 | -1 | -1 | -1 | -1 | -1 | 61 | -1 | -1 | -1 | -1 | -1 | 60 | -1 | -1 | -1 | -1 | -1 | -1 | -1 | -1 | -1 | -1 | -1 | -1 | -1 | -1 | 27 |
| 47 | -1 | 24 | -1 | -1 | -1 | -1 | -1 | -1 | -1 | 61 | -1 | -1 | -1 | -1 | -1 | -1 | 60 | -1 | -1 | -1 | -1 | -1 | -1 | -1 | -1 | -1 | -1 | -1 | -1 | 27 | -1 | -1 |
| 48 | 24 | -1 | -1 | -1 | -1 | -1 | -1 | -1 | 61 | -1 | -1 | -1 | -1 | -1 | -1 | -1 | 60 | -1 | -1 | -1 | -1 | -1 | -1 | -1 | -1 | -1 | -1 | -1 | 27 | -1 | -1 | -1 |

Fig. 7A

_700_   Exponent Matrix $P = E(H)$

| | 33 | 34 | 35 | 36 | 37 | 38 | 39 | 40 | 41 | 42 | 43 | 44 | 45 | 46 | 47 | 48 | 49 | 50 | 51 | 52 | 53 | 54 | 55 | 56 | 57 | 58 | 59 | 60 | 61 | 62 | 63 | 64 | 65 |
|---|---|---|---|---|---|---|---|---|---|---|---|---|---|---|---|---|---|---|---|---|---|---|---|---|---|---|---|---|---|---|---|---|---|
| 1 | 50 | -1 | -1 | -1 | -1 | -1 | -1 | -1 | -1 | -1 | 79 | -1 | -1 | -1 | -1 | -1 | -1 | -1 | -1 | -1 | 0 | -1 | -1 | -1 | -1 | -1 | -1 | -1 | -1 | -1 | -1 | -1 | -1 |
| 2 | -1 | 50 | -1 | -1 | -1 | -1 | -1 | -1 | -1 | -1 | -1 | 79 | -1 | -1 | -1 | -1 | -1 | 1 | -1 | -1 | -1 | 0 | -1 | -1 | -1 | -1 | -1 | -1 | -1 | -1 | -1 | -1 | -1 |
| 3 | -1 | -1 | 50 | -1 | -1 | -1 | -1 | -1 | -1 | -1 | -1 | -1 | 79 | -1 | -1 | -1 | -1 | -1 | -1 | -1 | -1 | -1 | 0 | -1 | -1 | -1 | -1 | -1 | -1 | -1 | -1 | -1 | -1 |
| 4 | -1 | -1 | -1 | 50 | -1 | -1 | -1 | -1 | -1 | -1 | -1 | -1 | -1 | 79 | -1 | -1 | -1 | -1 | -1 | -1 | -1 | -1 | -1 | 0 | -1 | -1 | -1 | -1 | -1 | -1 | -1 | -1 | -1 |
| 5 | 55 | -1 | -1 | -1 | -1 | -1 | -1 | 7 | -1 | -1 | -1 | -1 | -1 | -1 | -1 | -1 | -1 | -1 | -1 | 0 | -1 | -1 | -1 | 0 | -1 | -1 | -1 | -1 | -1 | -1 | -1 | -1 | -1 |
| 6 | -1 | 55 | -1 | -1 | -1 | -1 | 7 | -1 | -1 | -1 | -1 | -1 | -1 | -1 | -1 | -1 | -1 | -1 | -1 | 0 | -1 | -1 | -1 | 0 | -1 | -1 | -1 | -1 | -1 | -1 | -1 | -1 | -1 |
| 7 | -1 | -1 | 55 | -1 | -1 | 7 | -1 | -1 | -1 | -1 | -1 | -1 | -1 | -1 | -1 | -1 | -1 | -1 | -1 | 0 | -1 | -1 | -1 | -1 | 0 | -1 | -1 | -1 | -1 | -1 | -1 | -1 | -1 |
| 8 | -1 | -1 | -1 | 55 | 7 | -1 | -1 | -1 | -1 | -1 | -1 | -1 | -1 | -1 | -1 | -1 | -1 | -1 | -1 | 0 | -1 | -1 | -1 | -1 | 0 | -1 | -1 | -1 | -1 | -1 | -1 | -1 | -1 |
| 9 | 56 | -1 | -1 | -1 | -1 | -1 | -1 | 14 | -1 | -1 | -1 | -1 | -1 | -1 | -1 | -1 | -1 | -1 | 0 | -1 | -1 | -1 | 0 | -1 | -1 | -1 | -1 | -1 | -1 | -1 | -1 | -1 | -1 |
| 10 | -1 | 56 | -1 | -1 | -1 | -1 | 14 | -1 | -1 | -1 | -1 | -1 | -1 | -1 | -1 | -1 | -1 | -1 | 0 | -1 | -1 | -1 | 0 | -1 | -1 | -1 | -1 | -1 | -1 | -1 | -1 | -1 | -1 |
| 11 | -1 | -1 | 56 | -1 | -1 | 14 | -1 | -1 | -1 | -1 | -1 | -1 | -1 | -1 | -1 | -1 | -1 | -1 | 0 | -1 | -1 | -1 | -1 | 0 | -1 | -1 | -1 | -1 | -1 | -1 | -1 | -1 | -1 |
| 12 | -1 | -1 | -1 | 56 | 14 | -1 | -1 | -1 | -1 | -1 | -1 | -1 | -1 | -1 | -1 | -1 | -1 | -1 | 0 | -1 | -1 | -1 | -1 | 0 | -1 | -1 | -1 | -1 | -1 | -1 | -1 | -1 | -1 |
| 13 | 35 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | 0 |
| 14 | -1 | 35 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | 0 | -1 |
| 15 | -1 | -1 | 35 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | 0 | -1 | -1 |
| 16 | -1 | -1 | -1 | 35 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | 0 | -1 | -1 | -1 |
| 17 | -1 | -1 | -1 | 28 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 |
| 18 | -1 | -1 | 28 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 19 | -1 | 28 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 20 | 28 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 21 | -1 | -1 | -1 | 50 | -1 | -1 | -1 | -1 | -1 | -1 | -1 | -1 | -1 | -1 | -1 | 8 | -1 | -1 | -1 | -1 | -1 | -1 | -1 | -1 | -1 | -1 | -1 | -1 | -1 | -1 | -1 | -1 | -1 |
| 22 | -1 | -1 | 50 | -1 | -1 | -1 | -1 | -1 | -1 | -1 | -1 | -1 | -1 | -1 | 8 | -1 | -1 | -1 | -1 | -1 | -1 | -1 | -1 | -1 | -1 | -1 | -1 | -1 | -1 | -1 | -1 | -1 | -1 |
| 23 | -1 | 50 | -1 | -1 | -1 | -1 | -1 | -1 | -1 | -1 | -1 | -1 | -1 | 8 | -1 | -1 | -1 | -1 | -1 | -1 | -1 | -1 | -1 | -1 | -1 | -1 | -1 | -1 | -1 | -1 | -1 | -1 | -1 |
| 24 | 50 | -1 | -1 | -1 | -1 | -1 | -1 | -1 | -1 | -1 | -1 | -1 | 8 | -1 | -1 | -1 | -1 | -1 | -1 | -1 | -1 | -1 | -1 | -1 | -1 | -1 | -1 | -1 | -1 | -1 | -1 | -1 | -1 |
| 25 | -1 | 52 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 | -1 |
| 26 | 52 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 | -1 |
| 27 | -1 | -1 | -1 | 52 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 | -1 |
| 28 | -1 | -1 | 52 | -1 | -1 | -1 | -1 | -1 | -1 | -1 | -1 | -1 | -1 | -1 | -1 | -1 | -1 | -1 | 0 | -1 | -1 | -1 | -1 | -1 | -1 | -1 | -1 | -1 | -1 | -1 | -1 | -1 | -1 |
| 29 | -1 | 72 | -1 | -1 | -1 | -1 | -1 | -1 | -1 | 27 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 30 | 72 | -1 | -1 | -1 | -1 | -1 | -1 | -1 | 27 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 31 | -1 | -1 | -1 | 72 | -1 | -1 | -1 | -1 | -1 | -1 | -1 | 27 | -1 | -1 | -1 | -1 | -1 | -1 | -1 | -1 | -1 | -1 | -1 | -1 | -1 | -1 | -1 | -1 | -1 | -1 | -1 | -1 | -1 |
| 32 | -1 | -1 | 72 | -1 | -1 | -1 | -1 | -1 | -1 | -1 | 27 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 33 | -1 | -1 | -1 | 30 | -1 | -1 | -1 | -1 | -1 | -1 | -1 | -1 | -1 | -1 | -1 | 32 | -1 | -1 | -1 | -1 | -1 | -1 | -1 | -1 | -1 | -1 | -1 | -1 | -1 | -1 | -1 | -1 | -1 |
| 34 | -1 | -1 | 30 | -1 | -1 | -1 | -1 | -1 | -1 | -1 | -1 | -1 | -1 | -1 | 32 | -1 | -1 | -1 | -1 | -1 | -1 | -1 | -1 | -1 | -1 | -1 | -1 | -1 | -1 | -1 | -1 | -1 | -1 |
| 35 | -1 | 30 | -1 | -1 | -1 | -1 | -1 | -1 | -1 | -1 | -1 | -1 | -1 | 32 | -1 | -1 | -1 | -1 | -1 | -1 | -1 | -1 | -1 | -1 | -1 | -1 | -1 | -1 | -1 | -1 | -1 | -1 | -1 |
| 36 | 30 | -1 | -1 | -1 | -1 | -1 | -1 | -1 | -1 | -1 | -1 | -1 | 32 | -1 | -1 | -1 | -1 | -1 | -1 | -1 | -1 | -1 | -1 | -1 | -1 | -1 | -1 | -1 | -1 | -1 | -1 | -1 | -1 |
| 37 | -1 | 77 | -1 | -1 | 9 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 38 | 77 | -1 | -1 | -1 | -1 | 9 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 39 | -1 | -1 | -1 | 77 | -1 | -1 | 9 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 40 | -1 | -1 | 77 | -1 | -1 | -1 | 9 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 41 | -1 | -1 | -1 | -1 | -1 | -1 | -1 | -1 | -1 | -1 | 12 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 42 | -1 | -1 | -1 | -1 | -1 | -1 | -1 | -1 | -1 | 12 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 43 | -1 | -1 | -1 | -1 | -1 | -1 | -1 | -1 | -1 | -1 | -1 | -1 | 12 | -1 | -1 | -1 | -1 | -1 | -1 | -1 | -1 | -1 | -1 | -1 | -1 | -1 | -1 | -1 | -1 | -1 | -1 | -1 | -1 |
| 44 | -1 | -1 | -1 | -1 | -1 | -1 | -1 | -1 | -1 | -1 | -1 | 12 | -1 | -1 | -1 | -1 | -1 | -1 | -1 | -1 | -1 | -1 | -1 | -1 | -1 | -1 | -1 | -1 | -1 | -1 | -1 | -1 | -1 |
| 45 | 51 | -1 | -1 | -1 | -1 | -1 | -1 | -1 | -1 | -1 | -1 | -1 | 16 | -1 | -1 | -1 | -1 | -1 | -1 | -1 | -1 | -1 | -1 | -1 | -1 | -1 | -1 | -1 | -1 | -1 | -1 | -1 | -1 |
| 46 | -1 | 51 | -1 | -1 | -1 | -1 | -1 | -1 | -1 | -1 | -1 | -1 | 16 | -1 | N | -1 | -1 | -1 | -1 | -1 | -1 | -1 | -1 | -1 | -1 | -1 | -1 | -1 | -1 | -1 | -1 | -1 | -1 |
| 47 | -1 | -1 | 51 | -1 | -1 | -1 | -1 | -1 | -1 | -1 | -1 | -1 | -1 | 16 | -1 | -1 | -1 | -1 | -1 | -1 | -1 | -1 | -1 | -1 | -1 | -1 | -1 | -1 | -1 | -1 | -1 | -1 | -1 |
| 48 | -1 | -1 | -1 | 51 | -1 | -1 | -1 | -1 | -1 | -1 | -1 | -1 | -1 | -1 | 16 | -1 | -1 | -1 | -1 | -1 | -1 | -1 | -1 | -1 | -1 | -1 | -1 | -1 | -1 | -1 | -1 | -1 | -1 |

## Fig. 7A (Continued)

700     E     E(*H*)

| | 66 | 67 | 68 | 69 | 70 | 71 | 72 | 73 | 74 | 75 | 76 | 77 | 78 | 79 | 80 | 81 | 82 | 83 | 84 | 85 | 86 | 87 | 88 | 89 | 90 | 91 | 92 | 93 | 94 | 95 | 96 |
|---|----|----|----|----|----|----|----|----|----|----|----|----|----|----|----|----|----|----|----|----|----|----|----|----|----|----|----|----|----|----|----|
| 1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 2 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 3 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 4 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 5 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 6 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 7 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 8 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 9 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 10 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 11 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 12 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 13 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 14 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 15 | -1 | 0 | -1 | -1 | -1 | -1 | -1 | -1 | -1 | -1 | -1 | -1 | -1 | -1 | ℕ | -1 | -1 | -1 | -1 | -1 | -1 | -1 | -1 | -1 | -1 | -1 | -1 | -1 | -1 | -1 | -1 |
| 16 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 17 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 18 | -1 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 19 | -1 | 0 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 20 | -1 | -1 | 0 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 21 | -1 | -1 | -1 | 0 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 22 | -1 | -1 | -1 | -1 | 0 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 | -1 |
| 23 | -1 | -1 | -1 | -1 | -1 | 0 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 | -1 |
| 24 | -1 | -1 | -1 | -1 | -1 | -1 | 0 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 | -1 |
| 25 | -1 | -1 | -1 | -1 | -1 | -1 | -1 | 0 | -1 | -1 | -1 | 0 | -1 | -1 | -1 | -1 | -1 | -1 | -1 | -1 | -1 | -1 | -1 | -1 | -1 | -1 | -1 | -1 | -1 | -1 | -1 |
| 26 | -1 | -1 | -1 | -1 | -1 | -1 | -1 | -1 | 0 | -1 | -1 | -1 | 0 | -1 | -1 | -1 | -1 | -1 | -1 | -1 | -1 | -1 | -1 | -1 | -1 | -1 | -1 | -1 | -1 | -1 | -1 |
| 27 | -1 | -1 | -1 | -1 | -1 | -1 | -1 | -1 | -1 | 0 | -1 | -1 | -1 | 0 | -1 | -1 | -1 | -1 | -1 | -1 | -1 | -1 | -1 | -1 | -1 | -1 | -1 | -1 | -1 | -1 | -1 |
| 28 | -1 | -1 | -1 | -1 | -1 | -1 | -1 | -1 | -1 | -1 | 0 | -1 | -1 | -1 | 0 | -1 | -1 | -1 | -1 | -1 | -1 | -1 | -1 | -1 | -1 | -1 | -1 | -1 | -1 | -1 | -1 |
| 29 | -1 | -1 | -1 | -1 | -1 | -1 | -1 | -1 | -1 | -1 | -1 | 0 | -1 | -1 | -1 | 0 | -1 | -1 | -1 | -1 | -1 | -1 | -1 | -1 | -1 | -1 | -1 | -1 | -1 | -1 | -1 |
| 30 | -1 | -1 | -1 | -1 | -1 | -1 | -1 | -1 | -1 | -1 | -1 | -1 | 0 | -1 | -1 | -1 | 0 | -1 | -1 | -1 | -1 | -1 | -1 | -1 | -1 | -1 | -1 | -1 | -1 | -1 | -1 |
| 31 | -1 | -1 | -1 | -1 | -1 | -1 | -1 | -1 | -1 | -1 | -1 | -1 | -1 | 0 | -1 | -1 | -1 | 0 | -1 | -1 | -1 | -1 | -1 | -1 | -1 | -1 | -1 | -1 | -1 | -1 | -1 |
| 32 | -1 | -1 | -1 | -1 | -1 | -1 | -1 | -1 | -1 | -1 | -1 | -1 | -1 | -1 | 0 | -1 | -1 | -1 | 0 | -1 | -1 | -1 | -1 | -1 | -1 | -1 | -1 | -1 | -1 | -1 | -1 |
| 33 | -1 | -1 | -1 | -1 | -1 | -1 | -1 | -1 | -1 | -1 | -1 | -1 | -1 | -1 | -1 | 0 | -1 | -1 | -1 | 0 | -1 | -1 | -1 | -1 | -1 | -1 | -1 | -1 | -1 | -1 | -1 |
| 34 | -1 | -1 | -1 | -1 | -1 | -1 | -1 | -1 | -1 | -1 | -1 | -1 | -1 | -1 | -1 | -1 | 0 | -1 | -1 | -1 | 0 | -1 | -1 | -1 | -1 | -1 | -1 | -1 | -1 | -1 | -1 |
| 35 | -1 | -1 | -1 | -1 | -1 | -1 | -1 | -1 | -1 | -1 | -1 | -1 | -1 | -1 | -1 | -1 | -1 | 0 | -1 | -1 | -1 | 0 | -1 | -1 | -1 | -1 | -1 | -1 | -1 | -1 | -1 |
| 36 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | 0 | -1 | -1 | -1 | -1 | -1 | -1 | -1 | -1 |
| 37 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | 0 | -1 | -1 | -1 | -1 | -1 | -1 | -1 |
| 38 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | 0 | -1 | -1 | -1 | -1 | -1 | -1 |
| 39 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | 0 | -1 | -1 | -1 | -1 | -1 |
| 40 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | 0 | -1 | -1 | -1 | -1 |
| 41 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | 0 | -1 | -1 | -1 |
| 42 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | 0 | -1 | -1 |
| 43 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | 0 | -1 |
| 44 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 | 0 |
| 45 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 | -1 |
| 46 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 | -1 |
| 47 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 | -1 |
| 48 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | -1 | 0 |

Fig. 7A (Continued)

Parity Check Matrix $H$

750

## Fig. 7B

Fig. 7C

800

| $L=1944, E(H)$ | $\xrightarrow{\Gamma_1}$ | $L=3888, E(H)$ | $\xrightarrow{\Gamma_2}$ | $L=7776, E(H)$ |
|---|---|---|---|---|

802           804           806

# Fig. 8A

820

**Binary Matrix Γ1**

| | 1 | 2 | 3 | 4 | 5 | 6 | 7 | 8 | 9 | 10 | 11 | 12 | 13 | 14 | 15 | 16 | 17 | 18 | 19 | 20 | 21 | 22 | 23 | 24 |
|---|---|---|---|---|---|---|---|---|---|---|---|---|---|---|---|---|---|---|---|---|---|---|---|---|
| 1 | 0 | 1 | 1 | 1 | 1 | 0 | 0 | 1 | 0 | 1 | 0 | 1 | 1 | 1 | 0 | 0 | 1 | 0 | 1 | 1 | 0 | 0 | 1 | 1 |
| 2 | 1 | 1 | 1 | 0 | 0 | 1 | 0 | 1 | 0 | 1 | 1 | 1 | 0 | 1 | 0 | 1 | 0 | 1 | 0 | 0 | 1 | 0 | 0 | 1 |
| 3 | 0 | 0 | 1 | 1 | 1 | 1 | 1 | 0 | 1 | 0 | 0 | 1 | 0 | 1 | 1 | 1 | 1 | 1 | 1 | 0 | 0 | 1 | 0 | 0 |
| 4 | 1 | 0 | 0 | 1 | 1 | 0 | 1 | 1 | 1 | 0 | 1 | 1 | 0 | 0 | 0 | 1 | 0 | 1 | 1 | 1 | 0 | 1 | 1 | 0 |

Fig. 8B

840

Binary Matrix Γ2

| | 1 | 2 | 3 | 4 | 5 | 6 | 7 | 8 | 9 | 10 | 11 | 12 | 13 | 14 | 15 | 16 | 17 | 18 | 19 | 20 | 21 | 22 | 23 | 24 |
|---|---|---|---|---|---|---|---|---|---|---|---|---|---|---|---|---|---|---|---|---|---|---|---|---|
| 1 | 1 | 0 | 0 | 1 | 1 | 0 | 1 | 0 | 0 | 1 | 1 | 0 | 1 | 0 | 0 | 1 | 1 | 1 | 0 | 1 | 0 | 0 | 1 | 1 |
| 2 | 1 | 0 | 0 | 1 | 0 | 1 | 0 | 0 | 1 | 1 | 1 | 1 | 0 | 1 | 0 | 0 | 0 | 0 | 1 | 1 | 1 | 0 | 0 | 1 |
| 3 | 1 | 1 | 1 | 0 | 1 | 1 | 0 | 0 | 1 | 1 | 1 | 0 | 0 | 0 | 1 | 1 | 1 | 0 | 1 | 1 | 0 | 1 | 0 | 0 |
| 4 | 1 | 0 | 1 | 1 | 1 | 1 | 1 | 1 | 0 | 1 | 1 | 1 | 0 | 1 | 1 | 1 | 0 | 1 | 0 | 1 | 0 | 1 | 1 | 0 |

Fig. 8C

900

$L=1944, E(H)$ → λ → $L=7776, E(\ddot{H})$

902       904

# Fig. 9A

Binary Matrix λ

950

Fig. 9B

950

Binary Matrix λ

| | 49 | 50 | 51 | 52 | 53 | 54 | 55 | 56 | 57 | 58 | 59 | 60 | 61 | 62 | 63 | 64 | 65 | 66 | 67 | 68 | 69 | 70 | 71 | 72 | 73 | 74 | 75 | 76 | 77 | 78 | 79 | 80 | 81 | 82 | 83 | 84 | 85 | 86 | 87 | 88 | 89 | 90 | 91 | 92 | 93 | 94 | 95 | 96 |
|---|---|---|---|---|---|---|---|---|---|---|---|---|---|---|---|---|---|---|---|---|---|---|---|---|---|---|---|---|---|---|---|---|---|---|---|---|---|---|---|---|---|---|---|---|---|---|---|---|
| 1 | 0 | 0 | 0 | 1 | 0 | 0 | 1 | 0 | 1 | 0 | 0 | 0 | 0 | 1 | 0 | 0 | 0 | 0 | 0 | 1 | 0 | 1 | 0 | 0 | 0 | 0 | 1 | 0 | 0 | 0 | 0 | 1 | 1 | 0 | 0 | 0 | 1 | 0 | 0 | 0 | 0 | 0 | 0 | 1 | 0 | 0 | 0 | 1 |
| 2 | 0 | 0 | 1 | 0 | 0 | 0 | 0 | 1 | 0 | 1 | 0 | 0 | 1 | 0 | 0 | 0 | 0 | 0 | 1 | 0 | 1 | 0 | 0 | 0 | 0 | 0 | 0 | 1 | 0 | 0 | 1 | 0 | 0 | 1 | 0 | 0 | 0 | 1 | 0 | 0 | 0 | 0 | 1 | 0 | 0 | 0 | 1 | 0 |
| 3 | 0 | 1 | 0 | 0 | 1 | 0 | 0 | 0 | 0 | 0 | 1 | 0 | 0 | 0 | 0 | 1 | 0 | 1 | 0 | 0 | 0 | 0 | 0 | 1 | 1 | 0 | 0 | 0 | 0 | 1 | 0 | 0 | 0 | 0 | 1 | 0 | 0 | 0 | 1 | 0 | 0 | 1 | 0 | 0 | 0 | 1 | 0 | 0 |
| 4 | 1 | 0 | 0 | 0 | 0 | 1 | 0 | 0 | 0 | 0 | 0 | 1 | 0 | 0 | 1 | 0 | 1 | 0 | 0 | 0 | 0 | 0 | 1 | 0 | 0 | 1 | 0 | 0 | 1 | 0 | 0 | 0 | 0 | 0 | 0 | 1 | 0 | 0 | 0 | 1 | 1 | 0 | 0 | 0 | 1 | 0 | 0 | 0 |
| 5 | 1 | 0 | 0 | 0 | 0 | 0 | 0 | 1 | 1 | 0 | 0 | 0 | 0 | 0 | 0 | 1 | 0 | 1 | 0 | 0 | 0 | 0 | 0 | 1 | 0 | 0 | 1 | 0 | 0 | 0 | 1 | 0 | 0 | 0 | 0 | 0 | 1 | 1 | 0 | 0 | 0 | 1 | 0 | 0 | 0 | 0 | 0 | 1 |
| 6 | 0 | 1 | 0 | 0 | 0 | 0 | 1 | 0 | 0 | 1 | 0 | 0 | 0 | 0 | 0 | 1 | 0 | 1 | 0 | 0 | 0 | 0 | 0 | 1 | 1 | 0 | 0 | 0 | 1 | 0 | 0 | 0 | 0 | 0 | 1 | 0 | 0 | 1 | 0 | 0 | 0 | 1 | 0 | 0 | 0 | 0 | 1 | 0 |
| 7 | 0 | 0 | 1 | 0 | 0 | 1 | 0 | 0 | 0 | 0 | 1 | 0 | 1 | 0 | 0 | 0 | 0 | 0 | 1 | 0 | 1 | 0 | 0 | 0 | 0 | 0 | 1 | 0 | 0 | 0 | 1 | 0 | 0 | 1 | 0 | 1 | 0 | 0 | 0 | 0 | 1 | 0 | 0 | 0 | 1 | 0 | 0 | 1 |
| 8 | 0 | 0 | 0 | 1 | 1 | 0 | 0 | 0 | 0 | 0 | 0 | 1 | 0 | 1 | 0 | 0 | 0 | 0 | 0 | 1 | 0 | 1 | 0 | 0 | 0 | 0 | 1 | 0 | 0 | 0 | 1 | 0 | 1 | 0 | 0 | 0 | 0 | 0 | 0 | 1 | 0 | 0 | 0 | 1 | 1 | 0 | 0 | 0 |
| 9 | 1 | 0 | 0 | 0 | 0 | 1 | 0 | 0 | 0 | 0 | 1 | 0 | 0 | 0 | 1 | 0 | 0 | 0 | 1 | 0 | 1 | 0 | 0 | 0 | 1 | 0 | 1 | 0 | 0 | 1 | 0 | 0 | 0 | 0 | 0 | 0 | 1 | 1 | 0 | 0 | 0 | 1 | 0 | 0 | 1 | 0 | 0 |
| 10 | 0 | 1 | 0 | 0 | 0 | 0 | 1 | 0 | 0 | 1 | 0 | 0 | 1 | 0 | 0 | 0 | 1 | 0 | 0 | 0 | 1 | 0 | 0 | 1 | 0 | 1 | 0 | 0 | 0 | 0 | 1 | 0 | 0 | 0 | 0 | 1 | 0 | 0 | 1 | 0 | 0 | 0 | 1 | 0 | 0 |
| 11 | 0 | 0 | 1 | 0 | 1 | 0 | 0 | 0 | 0 | 1 | 0 | 0 | 0 | 1 | 0 | 0 | 0 | 1 | 0 | 0 | 1 | 0 | 0 | 0 | 0 | 1 | 0 | 0 | 0 | 0 | 1 | 0 | 0 | 1 | 0 | 0 | 1 | 0 | 0 | 0 | 0 | 1 | 0 | 0 | 0 | 1 | 0 |
| 12 | 0 | 0 | 0 | 1 | 0 | 1 | 0 | 0 | 1 | 0 | 0 | 0 | 1 | 0 | 0 | 0 | 1 | 0 | 0 | 0 | 0 | 1 | 0 | 0 | 1 | 0 | 0 | 0 | 0 | 1 | 0 | 0 | 0 | 0 | 1 | 1 | 0 | 0 | 0 | 0 | 0 | 0 | 1 | 0 | 0 | 0 | 1 |
| 13 | 1 | 0 | 0 | 0 | 0 | 1 | 0 | 0 | 0 | 1 | 0 | 0 | 0 | 0 | 0 | 1 | 1 | 0 | 0 | 0 | 0 | 0 | 0 | 1 | 0 | 0 | 1 | 0 | 0 | 0 | 0 | 1 | 1 | 0 | 0 | 0 | 0 | 0 | 0 | 1 | 0 | 0 | 0 | 1 | 1 | 0 | 0 | 0 |
| 14 | 0 | 1 | 0 | 0 | 1 | 0 | 0 | 0 | 1 | 0 | 0 | 0 | 0 | 0 | 1 | 0 | 0 | 1 | 0 | 0 | 0 | 0 | 1 | 0 | 0 | 0 | 0 | 1 | 0 | 0 | 1 | 0 | 0 | 1 | 0 | 0 | 0 | 0 | 1 | 0 | 0 | 0 | 1 | 0 | 0 | 1 | 0 | 0 |
| 15 | 0 | 0 | 1 | 0 | 0 | 0 | 0 | 1 | 0 | 0 | 0 | 1 | 0 | 1 | 0 | 0 | 0 | 0 | 0 | 1 | 0 | 0 | 1 | 0 | 0 | 1 | 0 | 0 | 0 | 0 | 1 | 0 | 0 | 0 | 0 | 1 | 0 | 0 | 1 | 0 | 0 | 0 | 1 | 0 | 0 | 0 | 0 | 1 | 0 |
| 16 | 0 | 0 | 0 | 1 | 0 | 0 | 1 | 0 | 0 | 0 | 1 | 0 | 1 | 0 | 0 | 0 | 0 | 0 | 0 | 1 | 1 | 0 | 0 | 0 | 0 | 1 | 0 | 0 | 1 | 0 | 0 | 0 | 0 | 0 | 0 | 1 | 1 | 0 | 0 | 0 | 1 | 0 | 0 | 0 | 0 | 0 | 0 | 1 |

Fig. 9B (Continued)

EP 4 675 950 A1

1000

Determining, by a first device based at least on a first parity check matrix of a first quasi-cyclic-low-density parity-check (QC-LDPC) code according to a code rate R of 1/2, a second parity check matrix for a second QC-LDPC code. The second QC-LDPC code may have a code block size that is four times a code block size of the first QC-LDPC code 1002

Encoding, by the first device, data using the second binary parity check matrix 1004

Transmitting, by the first device, the encoded data 1006

Receiving, by the second device from the first device, the encoded data 1008

Determining, based at least on the first parity check matrix of the first quasi-cyclic-low-density parity-check (QC-LDPC) code according to a code rate R of 5/6, the second parity check matrix for the second QC-LDPC code. The second QC-LDPC code may have a code block size that is four times a code block size of the first QC-LDPC code 1010

Decoding, by the second device, the encoded data using the second binary parity check matrix 1012

## Fig. 10

Europäisches
Patentamt

European
Patent Office

Office européen
des brevets

# EUROPEAN SEARCH REPORT

**Application Number**

EP 25 18 6999

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2021/167800 A1 (SHIN JONGWOONG [KR] ET AL) 3 June 2021 (2021-06-03) | 1,2,7,8, 13,14 | INV. H04L1/00 H04M13/116 |
| A | * abstract * <br> * figure 1 * <br> * paragraph [0021] * <br> * paragraph [0046] * <br> * paragraph [0055] * <br> * paragraph [0102] - paragraph [0105] * <br> * paragraph [0111] * <br> ----- | 3-6, 9-12,15 | |
| A | LI HUAAN ET AL: "Efficient Construction of Quasi-Cyclic LDPC Codes With Multiple Lifting Sizes", <br> IEEE COMMUNICATIONS LETTERS, IEEE SERVICE CENTER, PISCATAWAY, NJ, US, <br> vol. 28, no. 4, <br> 31 January 2024 (2024-01-31), pages 754-758, XP011965913, <br> ISSN: 1089-7798, DOI: 10.1109/LCOMM.2024.3360450 <br> [retrieved on 2024-01-31] <br> * the whole document * <br> ----- | 1-15 | |

**TECHNICAL FIELDS SEARCHED (IPC)**

H03M
H04L

The present search report has been drawn up for all claims

| Place of search | Date of completion of the search | Examiner |
|---|---|---|
| The Hague | 3 November 2025 | Molinari, Fausto |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

 

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 25 18 6999

This annex lists the patent family members relating to the patent documents cited in the above-mentioned European search report.
The members are as contained in the European Patent Office EDP file on
The European Patent Office is in no way liable for these particulars which are merely given for the purpose of information.

03-11-2025

| Patent document cited in search report | Publication date | Patent family member(s) | Publication date |
|---|---|---|---|
| US 2021167800 A1 | 03-06-2021 | CN 109891755 A | 14-06-2019 |
| | | EP 3567730 A2 | 13-11-2019 |
| | | JP 2020501429 A | 16-01-2020 |
| | | KR 20180104759 A | 21-09-2018 |
| | | US 2021167800 A1 | 03-06-2021 |
| | | WO 2018128435 A2 | 12-07-2018 |

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 63667255

**Non-patent literature cited in the description**

- **RICHARDSON** ; **URBANKE**. *IEEE Transactions on Information Theory*, February 2001, vol. 47 (2)